# EUROPEAN PATENT SPECIFICATION

(11) **EP 1 662 510 B1**
(45) Date of publication and mention of the grant of the patent: **21.07.2010**
(21) Application number: 05004030.2
(22) Date of filing: 24.02.2005
(51) Int. Cl.: G11C 11/16

(54) **Arrangement of write lines in an MRAM device**
Anordnung der Schreiblinien in einer MRAM-Vorrichtung
Arrangement des lignes d'écriture dans un dispositif MRAM

(30) Priority: 30.11.2004 JP 2004346464
(43) Date of publication of application: 31.05.2006
(73) Proprietor: KABUSHIKI KAISHA TOSHIBA, Tokyo 105-8001 (JP)
(72) Inventor: Inaba, Tsuneo, c/o Toshiba Corporation, Minato-ku, Tokyo 105-8001 (JP)
(74) Representative: HOFFMANN EITLE

(56) References cited:
- US-A1- 2002 097 597
- US-A1- 2003 117 869
- US-A1- 2003 174 536
- US-A1- 2004 090 856

## Description

The present invention relates to a semiconductor memory device that performs a write operation using a current, and for example, to the arrangement and wiring configuration of write lines in a magnetic random access memory (MRAM).

An MRAM (see for example, "IEEE Journal of Solid-State Circuits", May 2003, Vol. 38, No. 5, pp. 769-773) is a memory that stores data by using the magnetoresistance effect. A voltage is used to write data in conventional flash memory and the like. On the other hand, a current is used to write data in MRAM.

Magnetic tunnel junction (MTJ) elements used in an MRAM utilize the tunneling magnetoresistance effect. An MTJ element generally has an insulating layer and two ferromagnetic layers which sandwich the insulating layer. One of the ferromagnetic layers is called a reference layer and has a direction of magnetization fixed. The other ferromagnetic layer is called a recording layer and does not have a direction of magnetization fixed.

The tunneling magnetoresistance effect is a phenomenon in which a tunneling current varies depending on whether or not the relative directions of spin of two ferromagnetic films are parallel or antiparallel. If the spins are parallel, the tunneling current is large, so that the MTJ elements have a small resistance. In this case, the resultant data is "0". On the other hand, if the spins are antiparallel, the tunnel current is small, so that the MTJ elements have a large resistance. In this case, the resultant data is "1". A write operation is performed by using a magnetic field induced by a current to set the direction of magnetization of the reference layer to be the same as or opposite to that of the reference layer.

U.S. Patent No. 6,545,90681 describes a magnetic memory device employing what is called a toggle write system. The magnetic memory device based on this system differs from conventional magnetic memory devices in the easy axis of magnetization of the MTJ element, the structure of the MTJ element, and the timing for conducting a write current.

The specification of Jpn. Pat. Appln. No. 2002-382393 (unpublished, corresponding U.S. Appln. No. 10/701,468) describes a magnetic memory device employing what is called a resistance-divided memory cell. In this system, one memory cell has two MTJ elements holding complementary data. A value for a read signal is determined by the ratio of the resistance of one MTJ element to the resistance of the other MTJ element.

In US 2003/0117869 there is disclosed a thin film magnetic memory device writing data with bi-directional current. An end of a selected bit line in a selected column is electrically coupled to an end of a corresponding current return line by one of first and second write column select gates, which are selectively turned on in response to results of column selection. A data write circuit sets the other end of the selected bit line and the other end of the current return line to one and the other of a power supply voltage and a ground voltage in accordance with a level of write data via one of first and second data buses and an inverted data bus, respectively.

In US 2002/0097597 there is disclosed a memory device comprising a plurality of bit lines and a plurality of word lines forming a cross-point array. A memory cell is located at each of the cross-points. A bit decoder and word decoder are coupled to the bit lines and word lines, respectively. A first series of switch circuits are coupled to and located along the adjacent bit lines resulting in the array being divided into segments along the adjacent bit lines such that a shortened programming current path is provided which results in decreased resistance across the device.

In US 2004/0090856 there is disclosed a thin film magnetic memory device including a program unit comprising two program cells having an electric resistance varying according to a magnetization direction thereof. The program cells are magnetized in the same direction in the initial state, that is, non-program state. In program state, the magnetization direction of one of the program cells selected according to program data is changed from the initial state. One-bit program data and information of whether the program unit stores program data or not can be read based on two program signals generated according to the electric resistances of the two program cells.

In US 2003/0174536 there is disclosed a thin film magnetic memory device in which each write word line has one end connected by a write drive circuit to a power supply voltage selectively and the other end to a ground voltage. The write drive circuit is staggered in arrangement and thus connected to either one or the other of each write word line. A write drive circuit has a first transistor and a second transistor. When a memory cell row corresponding to the write drive circuit is selected the first transistor connects a corresponding write word line to the power supply voltage to supply a data writing current and when an adjacent row is selected the transistor connects the corresponding write word line to the power supply voltage. The second transistor passes a magnetic field cancelling current, which cancels a magnetic field leaking from a data writing current of an adjacent row.

According to an aspect of the present invention, there is provided a semiconductor memory device according to claim 1.

The invention can be more fully understood from the following detailed description when taken in conjunction with the accompanying drawings, in which:
FIG. 1 is a diagram showing a semiconductor memory device according to each embodiment of the present invention;
FIG. 2 is a diagram showing essential parts of a semiconductor memory device according to an arrangement not in accordance with the present invention but useful in the understanding thereof;
FIGS. 3, 4, and 5 are diagrams each showing essential parts of a semiconductor memory device according to another example of the arrangement;
FIG. 6 is a diagram showing the vertical relationship between write lines and a connection line;
FIG. 7 is a diagram showing another example of the vertical relationship between the write lines and the connection line;
FIGS. 8, 9, 10, and 11 are diagrams each showing a state of a semiconductor memory device according to a first embodiment during a write;
FIGS. 12 and 13 are diagrams each showing a state of a semiconductor memory device according to a second embodiment during a write;
FIGS. 14 and 15 are diagrams each showing a state of a semiconductor memory device according to a third embodiment during a write;
FIGS. 16 and 17 are diagrams each showing a state of an MTJ element used in a toggle MRAM;
FIG. 18 is a diagram showing the direction of a current flowing through a write line;
FIG. 19 is a diagram showing a timing for supplying a write current;
FIGS. 20, 21, 22, 23, and 24 are diagrams each showing a state of an MTJ element during a write;
FIG. 25 is a diagram showing essential parts of a semiconductor memory device according to a fourth embodiment;
FIGS. 26 and 27 are diagrams each showing essential parts of a semiconductor memory device according to another example of the fourth embodiment;
FIG. 28 is a diagram showing essential parts of a semiconductor memory device according to a fifth embodiment;
FIGS. 29 and 30 are diagrams each showing essential parts of a semiconductor memory device according to another example of the fifth embodiment;
FIG. 31 is a diagram showing a resistance-divided type memory cell;
FIG. 32 is a diagram showing essential parts of a semiconductor memory device according to a sixth embodiment;
FIGS. 33, 34, and 35 are diagrams each showing essential parts of a semiconductor memory device according to another example of the sixth embodiment;
FIGS. 36 and 37 are diagrams showing the position of the connection line in the semiconductor memory device according to the first embodiment;
FIG. 38 is a diagram showing essential parts of a semiconductor memory device according to a seventh embodiment of the present invention;
FIGS. 39, 40, and 41 are diagrams each showing a part of the semiconductor memory device in FIG. 38 in detail;
FIGS. 42, 43, 44, and 45 are diagrams each showing a state of a semiconductor memory device according to the seventh embodiment during a write;
FIG. 46 is a diagram showing a switch circuit and control signals for the switch circuit;
FIGS. 47, 48, 49, 50, and 51 are diagrams each illustrating signals for a write bit line current circuit;
FIGS. 52, 53, 54, and 55 are diagrams each showing another example of essential parts of the semiconductor memory device according to the first embodiment;
FIG. 56 is a diagram showing a write bit line current circuit and control signals for the write bit line current circuit; and
FIG. 57 is a diagram showing another example of essential parts of the semiconductor memory device according to the seventh embodiment.
FIG. 58 is a diagram illustrating the sectional structure of MTJ element.
FIG. 59 is a diagram illustrating a write bit line current circuit and a write word line current circuit.

While developing the present invention, the inventors studied methods for realizing a magnetic memory device that can reduce the manufacturing cost. As a result, the inventors have obtained the knowledge described below.

In a general MRAM, a current is conducted through a write line to induce a magnetic field to write data to an MTJ element. The write operation indirectly uses a current in contrast to other types of semiconductor memory. Accordingly, a relatively large current is required to write data. Specifically, at present, a write current of one to several tens of mA is required.

Here, the voltage applied to a write line is assumed fixed. Then, the resistance required to obtain a sufficient write current is determined on the basis of Ohm's law (V=RI). The length of the write line is then determined on the basis of the determined wiring resistance. The maximum number of memory cells provided for the write line is then determined in accordance with the determined length. That is, with an MRAM, the current required for a write determines the scale of a memory cell array.

For a memory device, the scale of a memory array is maximized in order to lower the manufacturing cost by reducing the chip size. In other words, it is necessary to increase the number of memory cells provided for one write line. Increasing the length of a write line allows the number of memory cells to be increased. However, increasing in the length of the write line increases the wiring resistance.

It is possible to increase the write current by increasing the difference between potentials applied to the opposite ends of the write line. However, the power supply voltage is fixed for each generation. Further, a high-voltage-resistance transistor must be provided in order to allow the use of a potential equal to or higher than the power supply voltage. This undesirably increases the manufacturing cost.

Thus, the length of a write line has hitherto been limited to the one determined by the voltage applied to the write line and the length determined by the write current. In other words, the scale of the memory cell array is uniquely determined by the magnitude of the write current. Consequently, a reduction in write current has been the only method for increasing the scale of the memory cell array to reduce the chip size and thus the manufacturing cost.

With reference to the drawings, description will be given of embodiments of the present invention constructed on the basis of the above knowledge. In the description below, the same reference numerals are used to denote components having substantially the same functions and configurations. Duplicate descriptions will be given only when required.

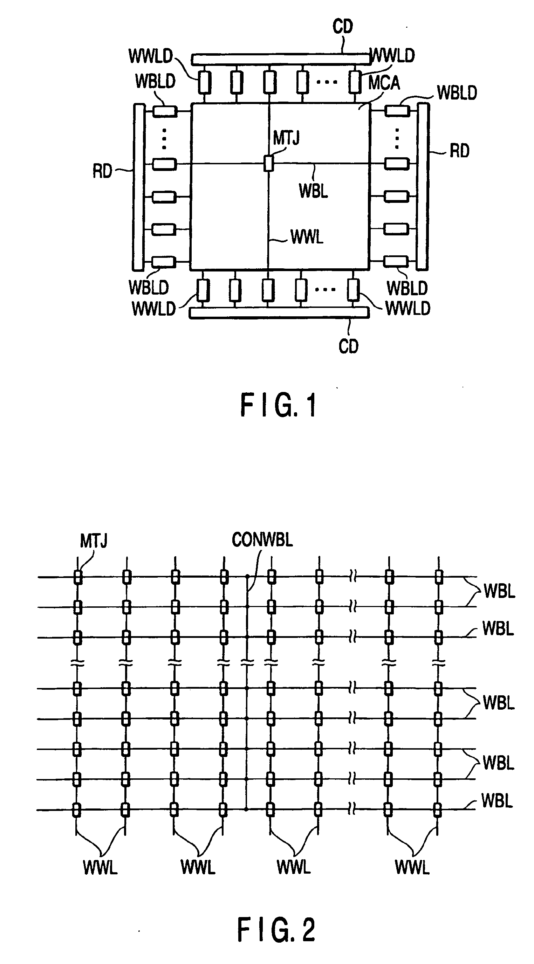

FIG. 1 schematically shows the configuration of a semiconductor memory device common to the embodiments of the present invention. FIG. 1 shows a memory cell array and a circuit relating to writes which are extracted from the semiconductor memory device. As shown in FIG. 1, the semiconductor memory device has a memory cell array MCA. As described later in detail, the memory cell array MCA has a plurality of MTJ elements MTJ, a plurality of write bit lines WBL extending in an x direction (the horizontal direction of the drawing), and a plurality of write word lines WWL extending in a y direction (the vertical direction of the drawing). The figure shows only one MTJ element MTJ, one write bit line, and one write word line.

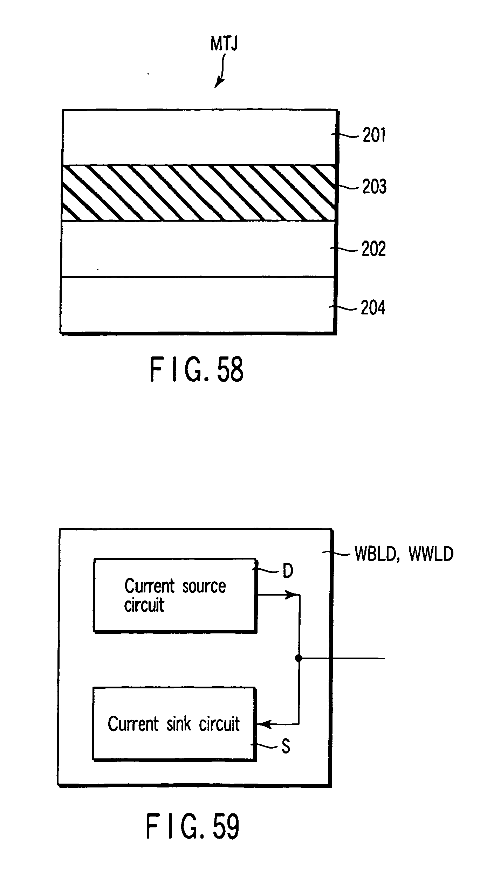

The MTJ element MTJ may have any configuration so long as it can store at least binary data in accordance with a magnetic field applied to the MTJ element MTJ. As shown in FIG. 58, a structure is typically used in which one insulating film 203 is sandwiched between two ferromagnetic films 201, 202. One of the ferromagnetic films has a direction of magnetization (direction of spin) fixed by an antiferromagnetic film 204 called pin layer. The fixed ferromagnetic film 202 is called a pinned layer, a fixed layer, a reference layer, or the like. The direction of magnetization of the other ferromagnetic film 201 can be reversed along the easy axis of magnetization. This ferromagnetic film is called a free layer, a memory layer, or the like. Binary data is stored depending on whether the directions of spins of the free layer and pin layer are antiparallel or parallel.

Data is typically written to the MTJ element MTJ by conducting a current through two write lines (write word line WWL and write bit line WBL) crossing each other at the MTJ element MTJ. This current causes synthesized magnetic fields generated around the two write lines to be applied to the MTJ element. The synthetic magnetic field reverses the directions of the spin of the free layer. Data is thus written. The direction of a current flowing through one or both of the two write lines is determined depending on the data being written.

Write bit line current circuits (driver/sinker) WBLD are connected to the opposite ends of each write bit line WBL. As shown in FIG. 59, each write bit line current circuit WBLD has a driver (current source circuit) D that drives the current into the write bit line and a sinker (current sink circuit) S that draws the current out of the write bit line. The write bit line current circuit WBLD is supplied with a control signal from a row decoder RD. Either the driver D or the sinker S is activated (operates) in accordance with the control signal. Whether the driver D or the sinker S is activated (operates) is determined so that a current flows in a direction corresponding to the data to write.

Likewise, write word line current circuits WWLD are connected to the opposite ends of each write word line WWL. Each write word line current circuit WWLD has a driver D and a sinker S, like the write bit line current circuit WBLD. The write word line current circuit WWLD is supplied with a control signal from a column decoder CD. During a write, either the driver D or the sinker S operates in accordance with the control signal. Whether the driver D or the sinker S operates is determined so that a current flows in a direction corresponding to the data to write.

The row decoder RD and the column decoder CD (control section) control the write line current circuits (write bit line current circuit WBLD and write word line current circuit WWLD) so that data is written to the MTJ element MTJ at an address in accordance with an address signal.

If the write current has only to flow in one direction, each of the write bit line current circuit WBLD and the write word line current circuit WWLD has only to have the functions of either the driver or sinker depending on the direction in which the current flows.

For simplification of description, only the parts required for writes are shown and will be described. For example, those skilled in the art can use the prior art to easily realize parts such as read word lines and selection transistors which are required for reads.

Now, with reference to FIG. 2, description will be given of a semiconductor memory device not according to the present invention but useful in the understanding thereof. FIG. 2 is a diagram schematically showing essential parts of a semiconductor memory device. FIG. 2 shows only the part of the memory cell array MCA in FIG. 1. As shown in FIG. 2, the memory cell array MCA is constructed by arranging a plurality of MTJ elements MTJ in a matrix, the MTJ elements serving as memory cells. For example, x (natural number greater than 1) MTJ elements MTJ are arranged along the vertical direction of the drawing, while y (natural number greater than 1) MTJ elements MTJ are arranged along the horizontal direction of the drawing.

As shown in FIG. 2, x write bit lines WBL extend in the horizontal direction of the drawing so as to pass through the MTJ elements arranged in the horizontal direction of the drawing. Similarly, y write word lines WWL extend in the vertical direction of the drawing so as to pass through the MTJ elements arranged in the vertical direction of the drawing. The write bit line WBL and the write word line WWL are electrically or magnetically or electrically and magnetically connected to the MTJ element located at the intersection between the write bit line WBL and the write word line WWL.

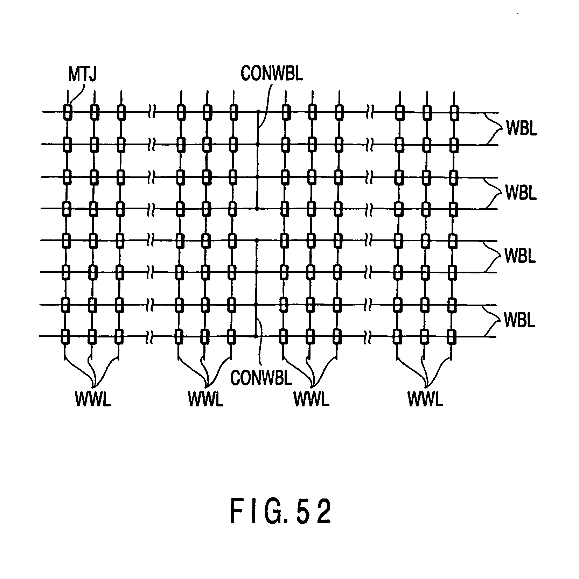

The write bit lines WBL are electrically connected together by a connection line (first connection line). The connection line CONWBL extends along the write word lines WWL. The connection line CONWBL may connect all the write lines WBL or, for example, the n-th (n is a natural number) power of 2 as shown in FIG. 52 (four write bit lines are illustrated in FIG. 52).

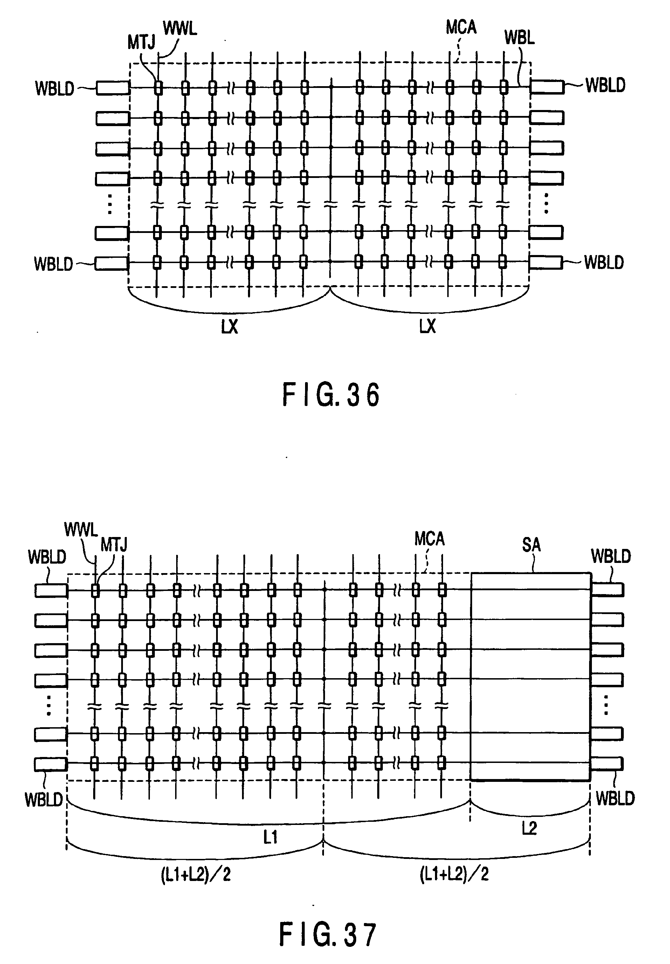

The connection line CONWBL can be placed at an arbitrary position of the memory cell array MCA such as its center or the vicinity of its end. However, typically, the connection line CONWBL is located in the center of the memory cell array MCA as shown in FIG. 36. In other words, the connection line CONWBL is located in the center of the write bit lines WBL. The term center as used herein means the center and its vicinity. More specifically, the center refers to a position such that the ratio of the length of the right part of the connection line CONWBL to its left part is at most 10%.

Even if a sense amplifier SA is provided between the memory cell array MCA and the write bit line driver WBLD as shown in FIG. 37, the connection line CONWBL can be placed at a similar position. Specifically, if the length of the write bit line WBL within the memory cell array MCA is defined as L1 and the length of the write bit line WBL within the sense amplifier SA is defined as L2, the connection line CONWBL is provided at a distance equal to (L1/L2)/2 from an end of the write bit line WBL. Also in this case, the lengths of the opposite parts of the write bit line WBL across the connection line CONWBL have only to be almost the same (for example, a difference of about 10% is permitted) and need not be perfectly the same. The connection line CONWBL is thus placed in the center of the write bit lines in order to balance the resistance values of the two parts of the write bit line WBL.

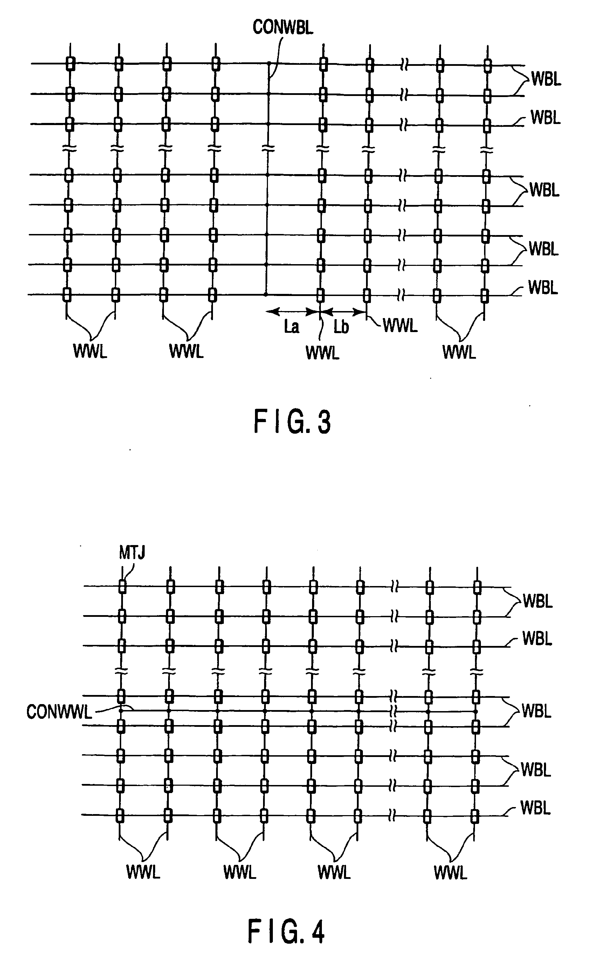

Further, as shown in FIG. 3, for the spacing between two columns with MTJ elements and write word line, only the spacing between two columns sandwiching the connection line CONWBL between them may be larger than that between the other pairs of columns. In this case, for example, the distance La between the connection line CONWBL and the adjacent MTJ element MTJ is set larger than the distance Lb between the MTJ element MTJ and the adjacent write word line. This makes it possible to reduce the possibility that a current flowing through the connection line CONWBL causes a miswrite to the MTJ element MTJ adjacent to the connection line CONWBL. The magnitude of a magnetic field induced by a current is in inverse proportion to the square of the distance. Accordingly, if the distance between a write line and an MTJ element is increased by a factor of 1.5, the magnetic field applied to the MTJ element decreases to about 44%.

Further, as shown in FIG. 4, the write word lines WWL may be electrically connected together by a connection line (second connection line) CONWWL. The connection line CONWWL extends along the write bit lines WBL. Typically, the connection line CONWWL is located in the center of the memory cell.

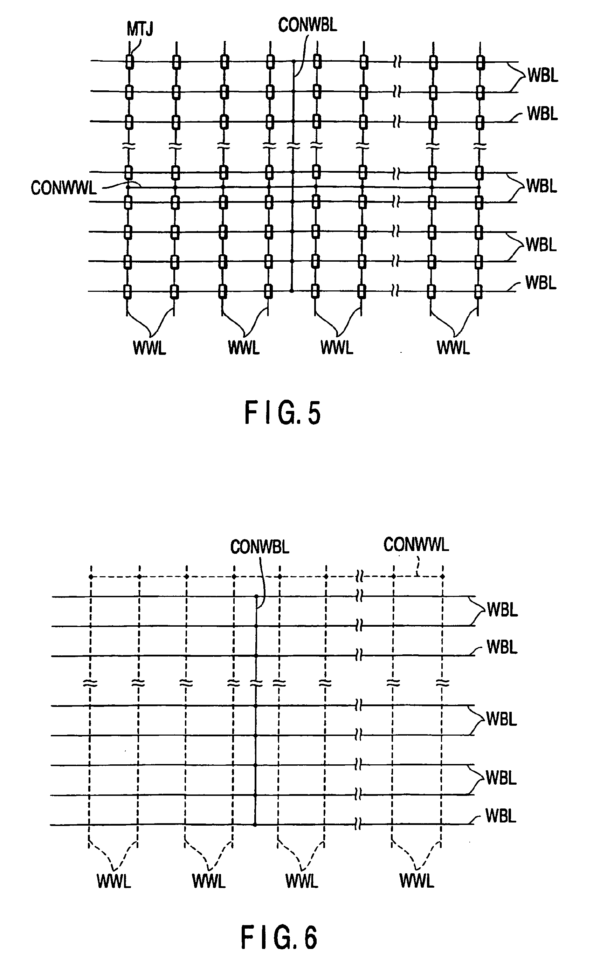

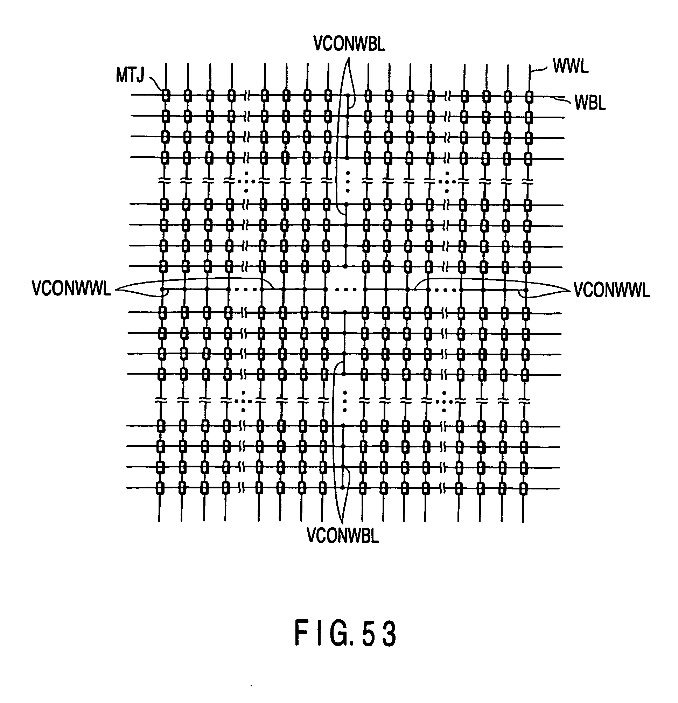

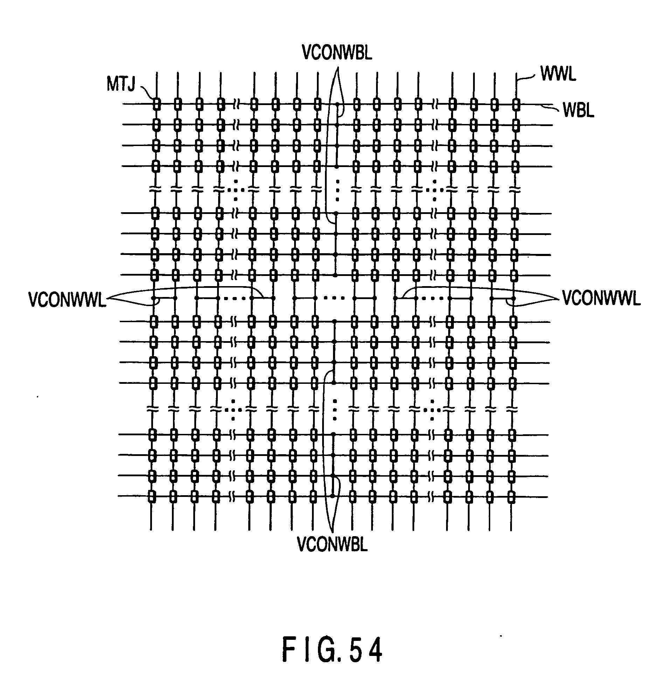

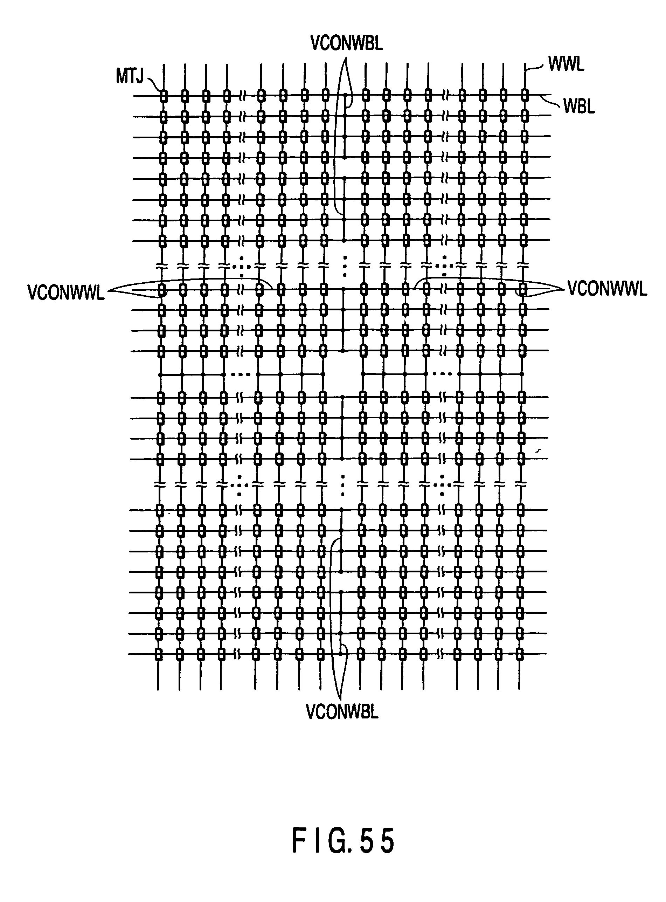

Moreover, as shown in FIG. 5, both connection line CONWWL and CONNBL may be provided. In this case, the number of write bit lines WBL connected together by the connection line CONWBL may be the same as (FIG. 53) or different from (FIG. 54) that of write word lines WWL connected together by the connection line CONWWL. FIG. 53 illustrates the case in which four write bit lines are connected together, while four write word lines are connected together. FIG. 54 illustrates the case in which four write bit lines are connected together, while two write word lines are connected together. Further, as shown in FIG. 55, the length of the write word line WWL (the number of MTJ elements MTJ along the direction of the write word lines WWL) may be larger than that of the write bit line WBL (the number of MTJ elements MTJ along the direction of the write bit lines WBL).

The connection line CONWBL may be provided in the same wiring layer as that of the write bit lines WBL or in a different layer. Likewise, the connection line CONWWL may be provided in the same wiring layer as that of the write word lines WWL or in a different layer.

When both connection lines CONWBL and CONWWL are provided, it is possible to provide the write bit lines WBL and the connection line CONWBL in the same wiring layer, while providing the write word lines WWL and the connection line CONWWL in the same wiring layer, for example, as shown in FIG. 6. In FIG. 6, for example, a solid line indicates a wiring layer above the MTJ elements MTJ. A broken line indicates a wiring layer below the MTJ elements MTJ.

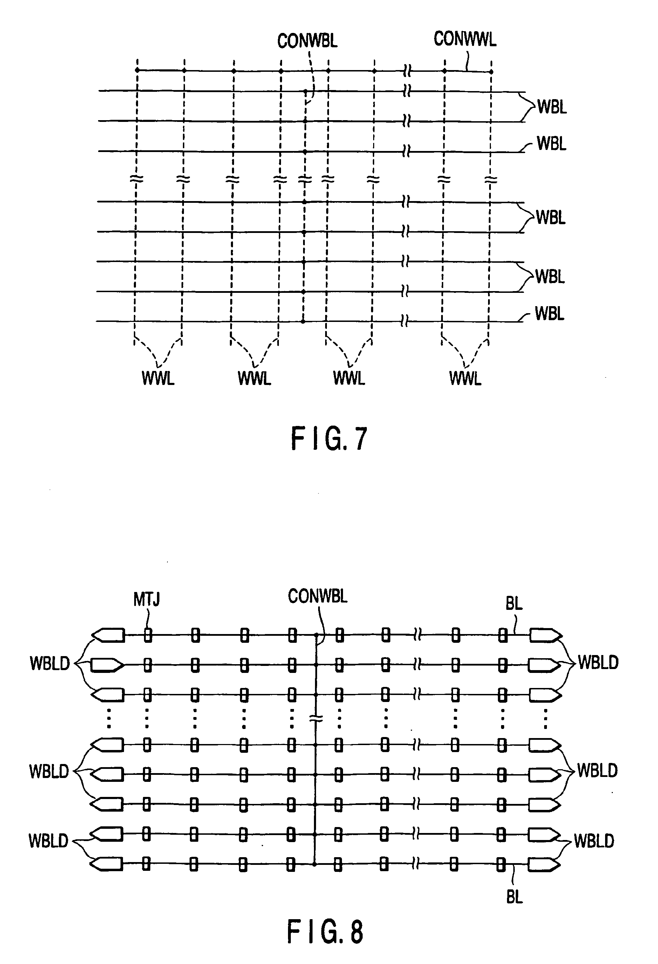

Alternatively, it is possible to provide the write bit lines WBL and the connection line CONWWL in the same wiring layer, while providing the write word lines WWL and the connection line CONWBL in the same wiring layer, as shown in FIG. 7. In this case, a contact is formed at the position of each black point to electrically connect two wiring layers together.

The connection line CONWBL electrically connects the write bit lines WBL. This reduces the effective wiring resistance of the write bit line WBL offered when the write current is conducted through the write bit line WBL. Accordingly, the write bit line WBL can be lengthened while maintaining the voltage applied across the write bit line and the write current. This enables an increase in the number of MTJ elements provided for one write bit line WBL and thus in the scale of the memory cell array MCA. The increase in the scale of the memory cell array MCA enables a reduction in chip size. As a result, the number of chips that can be manufactured from one wafer increases. Therefore, the manufacturing cost can be reduced.

Further, if the write word lines WWL are electrically connected together by the connection line CONWWL, similar advantages are also obtained by reducing the effective wiring resistance of the write word line WWL. Moreover, the provision of both connection lines CONWBL and CONWWL can increase the lengths of the write bit line WBL and write word line WWL. This further serves to reduce the manufacturing costs by increasing the scale of the memory cell array MCA.

### (First Embodiment)

A first embodiment relates to a method of conducting a current through the write lines in the semiconductor memory device.

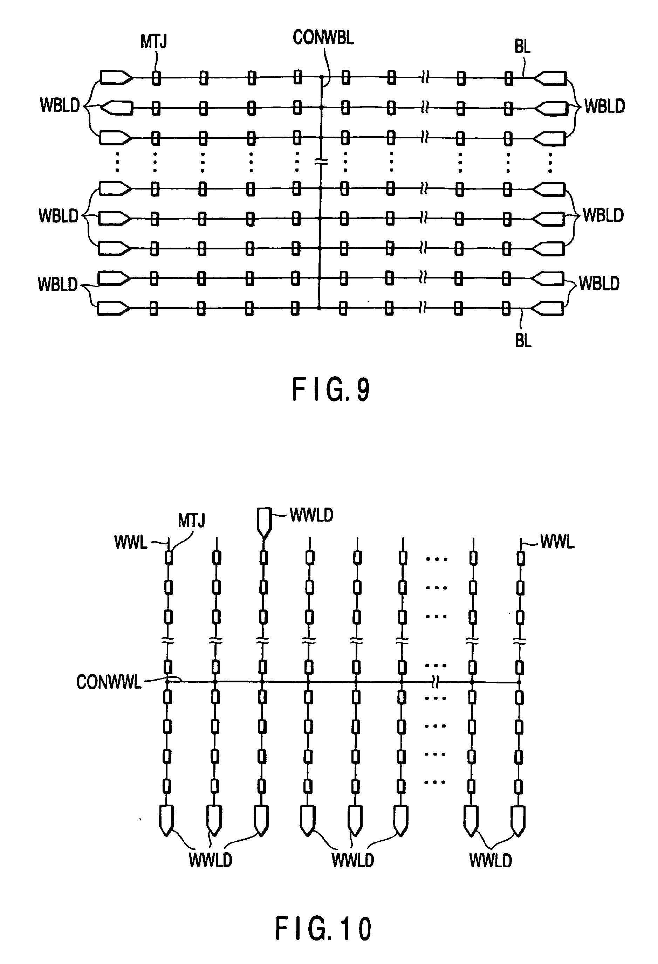

With reference to FIGS. 8 and 9, description will be given of the first embodiment. The following explanation corresponds to the case in which data is written to the MTJ elements MTJ located to the left of the connection line CONWBL in the configuration of the first embodiment shown in FIG. 2 as an example. More specifically, as an example of this case, a write is executed on the MTJ element (selected MTJ elements) through which the second write bit line WBL from the top of the drawing passes.

FIGS. 8 and 9 are diagrams schematically showing the state of essential parts of the first embodiment of the present invention during a write. In particular, in FIG. 8, the write current flows rightward in the drawing through the write bit line (selected write bit line) WBL passing through the selected MTJ element. In FIG. 9, the write current flows leftward in the drawing through the write bit line WBL. For those of the write bit line current circuits WBLD in FIGS. 8 and 9 in which the tip portion of their acute angle faces opposite the write bit line WBL, the sinker is operating. In FIGS. 8 and 9, the write word lines WWL are omitted. At standby, all the write bit lines WBL are precharged to a predetermined potential (for example, a common potential (ground potential)).

As shown in FIG. 8, if the write current flows through the selected write bit line WBL rightward in the drawing, then for the pair of write bit line current circuits (selected write bit line current circuits) WBLD connected to the selected write bit line, the driver operates in the left write bit line current circuit, whereas the sinker operates in the right write bit line current circuit.

The write current flowing from the selected left write bit line current circuit WBLD is dispersed to other write bit lines WBL via the connection line CONWBL. The sinkers draw the dispersed currents, so that the current flows rightward in the right part of the write bit line WBL with respect to the connection line CONWBL. The current flows leftward in the left part of the write bit line WBL with respect to the connection line CONWBL. Since the write current is thus dispersed to all the write bit lines WBL, the current flowing through each write bit line WBL decreases. For example, if the wiring resistance between the driver or sinker of each write bit line WBL and the connection line CONWBL is defined as R, the resistance value of a write current path decreases to R+R/(2n-1) (n is the number of write bit lines WBL connected together). If the write bit lines WBL are not connected together as in the prior art, the resistance value of the write current path is 2R. Accordingly, in qualitative terms, the resistance value can be reduced by about 33 to 50% depending on the value of n. It is thus possible to increase the wiring resistance of the write bit line WBL, that is, the length of the write bit line WBL.

If as shown in FIG. 9, the write current is conducted through the selected write bit line WBL leftward in the drawing, then for the pair of selected write bit line current circuits WBLD, the driver operates in the right write bit line current circuit WBLD, whereas the sinker operates in the left write bit line current circuit WBLD. The driver operates in the write bit line current circuits WBLD other than the selected ones WBLD.

The write current flowing out of the write bit line current circuit WBLD other than the right selected ones WBLD flows, via the connection line CONWBL, into the left part of the selected write bit line WBL with respect to the connection line CONWBL. In other words, the current flowing through the left part of the selected write bit line WBL is the sum of currents that all the drivers passes into the write bit lines. Thus, a sufficiently large current can be conducted through the part of the selected write bit line WBL which passes through the selected MTJ elements MTJ even if the wiring resistance of the write bit line WBL is increased, that is, the length of the write bit line WBL is increased. In other words, a sufficient write current can be conducted, while the length of the write bit line WBL can be increased.

In FIG. 8, not all the sinkers in the bit line current circuits WBLD other than the selected write bit line current circuits WBLD have to operate. At least one sinker has only to operate. Further, in FIG. 9, in the bit line current circuits WBLD other than the selected write bit line current circuits WBLD, at least one driver has only to operate. This also applies to the embodiments described below.

Description has been given in conjunction with the case in which the selected MTJ elements MTJ are located to the left of the connection line CONWBL. The above description also applies to the case in which the selected MTJ elements are located to the right of the connection line CONWBL. That is, if the current flows rightward through the selected write bit line WBL, the driver operates in the selected left write bit line current circuit WBLD, whereas the sinker operates in the selected right write bit line current circuit WBLD. If the current flows leftward through the selected write bit line WBL, the driver operates in the selected right write bit line current circuit WBLD, whereas the sinker operates in the selected left write bit line current circuit WBLD. The sinker operates in the other write bit line current circuits WBLD.

The description has been given of the write bit line WBL, that is, of the example of the arrangement shown in FIG. 2. However, in the example shown in FIG. 4, whether the driver or the sinker is activated in each write word line current circuit WWLD is similarly determined.

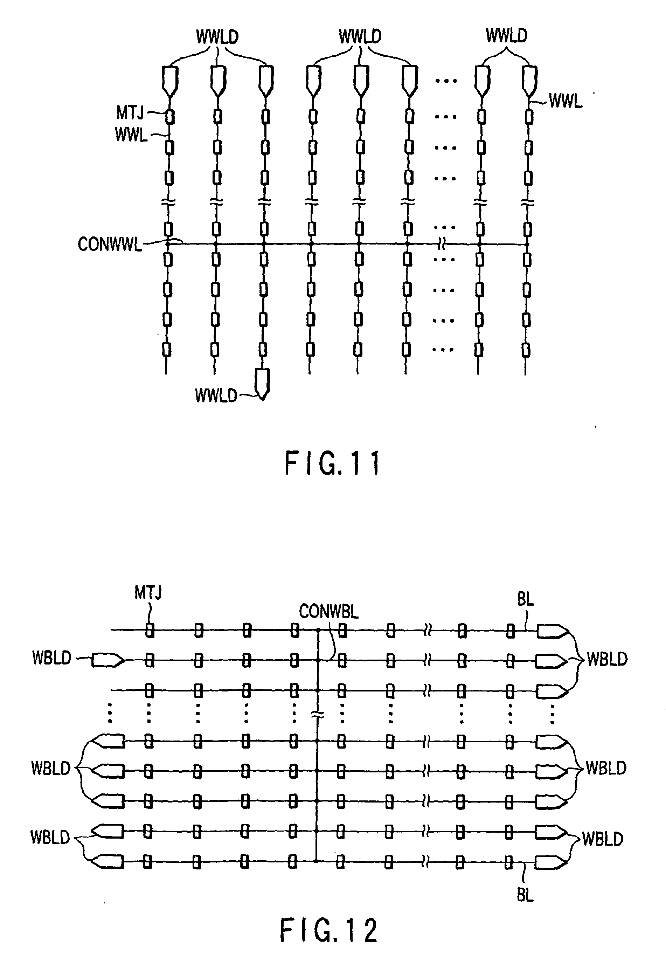

A current flowing through a write line in only one direction also may realize a write. Now, this will be described in conjunction with the case shown in FIG. 4. FIGS. 10 and 11 each schematically show a state of the first embodiment during a write. In these figures, a current flows through the write bit line WBL in only one direction, for example, from the top to bottom of the drawings.

If the selected MTJ elements are located above the connection line CONWWL, then as shown in FIG. 10, only the driver connected to the selected write word line WWL operates. The other drivers does not operate. On the other hand, all the sinkers operate.

If the selected MTJ elements are located below the connection line CONWWL, then as shown in FIG. 11, only the sinker connected to the selected write word line WWL operates. The other sinkers do not operate. On the other hand, all the drivers operate. This control allows a sufficient write current to be conducted through the part of the write line which passes through the selected MTJ elements, while allowing the length of the write line to be increased, even if the write current circuit has only one of the driver and sinker. In FIGS. 10 and 11, the write bit lines WBL are also omitted.

Moreover, in the example shown in FIG. 5, by combining the several types of control shown in the present embodiment together, it is possible to provide a sufficient write current for both write bit line WBL and write word line WWL, while increasing the lengths of the lines.

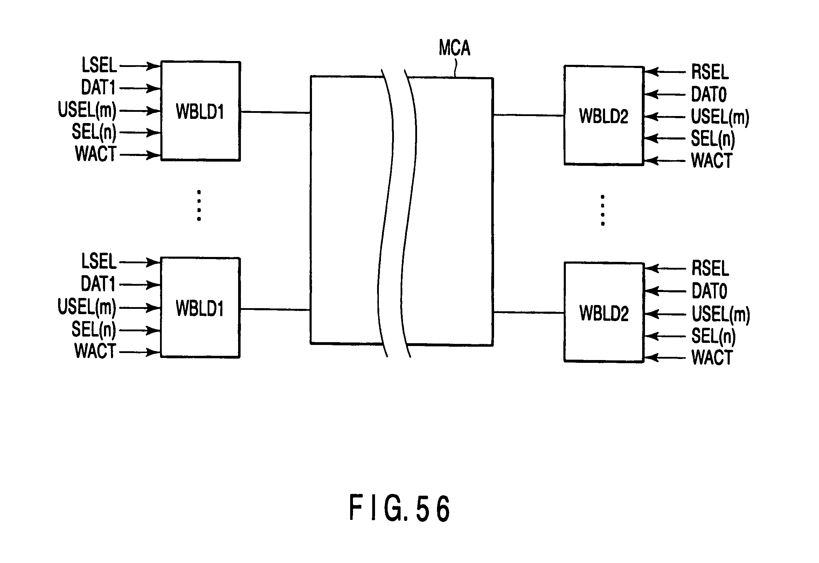

Now, description will be given of the control of the write bit line current circuit WBLD and the write word line current circuit WWLD. FIG. 56 is a diagram showing a write bit line current circuit and control signals for it. As shown in FIG. 56, each write bit line current circuit WBLD1 in the left part of the drawing is supplied with control signals LSEL, DAT1, and WACT and address signals USEL(m) and SEL(n). Each write bit line current circuit WBLD2 in the right part of the drawing is supplied with control signals RSEL, DAT0, and WACT and address signals USEL(m) and SEL(n). Note that m is the number of write bit line groups which is constituted with one connection line CONWBL, and n is the number of write bit lines WBL constituting one bit line group.

In the description below, the write bit lines WBL connected together by one connection line CONWBL and the MTJ elements MTJ through which the write bit line WBL pass are called an interconnected unit. The description below will be given only of the write bit line WBL and the write bit line current circuit WBLD. However, exactly the same description applies to the write word line WWL and write word line current circuit WWLD.

The write bit line current circuit WBLD is controlled in accordance with a combination of the control signals LSEL, RSEL, DAT0, DAT1, USEL(m), SEL(n), and WACT. As a result, in accordance with the positions of the selected MTJ elements, the positions of the selected MTJ elements with respect to the connection line CONWBL, and write data, a state similar to the one shown in FIG. 8 or 9 or other figures is formed, with a magnetic field applied to the selected MTJ elements.

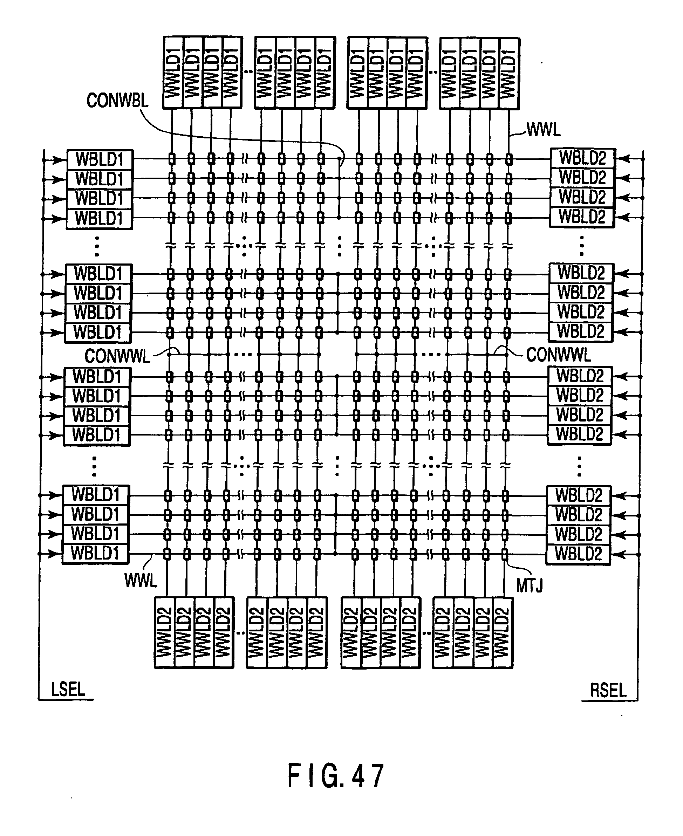

FIG. 47 is a diagram showing the control signals LSEL and RSEL. The control signal LSEL is supplied to all the write bit line current circuits WBLD1. The control signal LSEL indicates that the selected MTJ elements are located to the left of the connection line CONWBL. In this case, the control signal LSEL is, for example, at a high level. The control signal RSEL is supplied to all the write bit line current circuits WBLD2. The control signal RSEL indicates that the selected MTJ elements are located to the right of the connection line CONWBL. The control signal RSEL is, for example, at the high level to indicate this case. Further, the control signals LSEL and RSEL are supplied to the write word line current circuit WWLD1 and WWLD2 as row addresses.

Similarly, the write word line current circuit WWLD1 is supplied with a signal indicating that the selected MTJ elements are located above the connection line CONWBL. The write word line current circuit WWLD2 is supplied with a signal indicating that the selected MTJ elements are located below the connection line CONWBL.

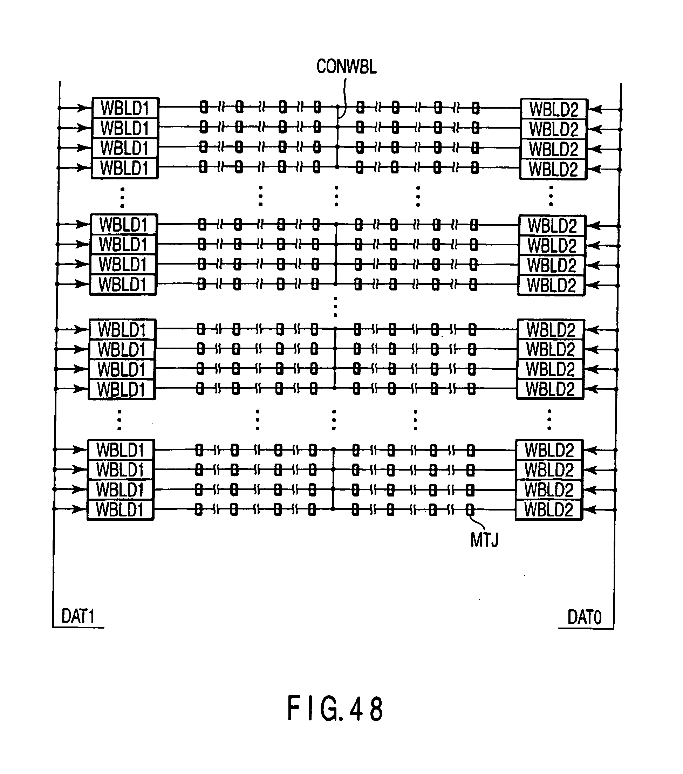

FIG. 48 is a diagram illustrating the control signals DAT0 and DAT1. The control signal DAT0 is supplied to all the write bit line current circuits WBLD2. The control signal DAT0 indicates that the write data is "0" and in this case, is, for example, at the high level. The control signal DAT1 is supplied to all the write bit line current circuits WBLD1. The control signal DAT1 indicates that the write data is "1" and in this case, is, for example, at the high level. The control signals DAT0 and DAT1 are complementary.

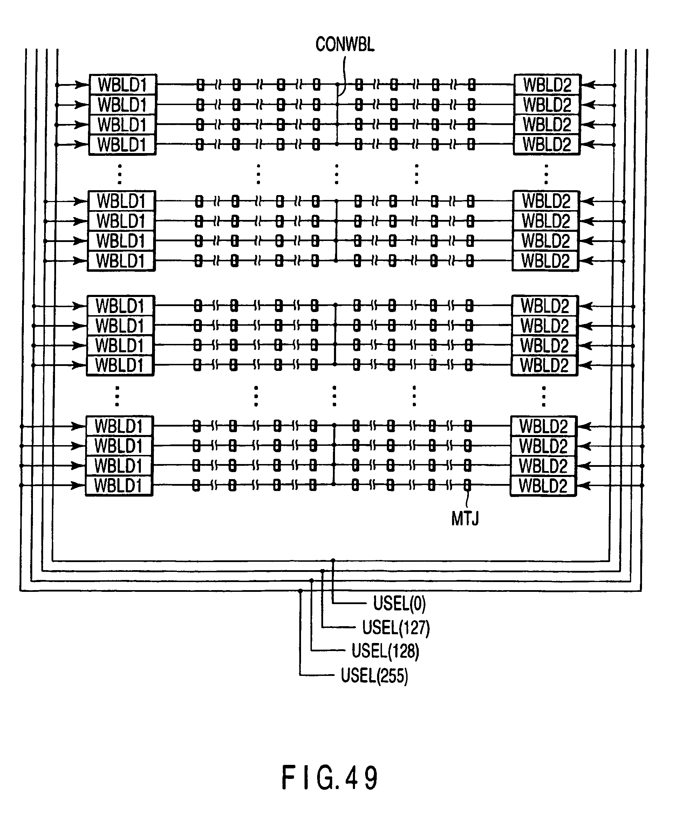

FIG. 49 is a diagram illustrating the address signal USEL(m) in which n is 255. An address signal USEL(0) is supplied to all the write bit line current circuits WBLD1 and WBLD2 connected to the first interconnected unit. Similarly, the address signal USEL(x) is supplied to all the write bit line current circuits WBLD1 and WBLD2 connected to the x+1-th interconnected unit.

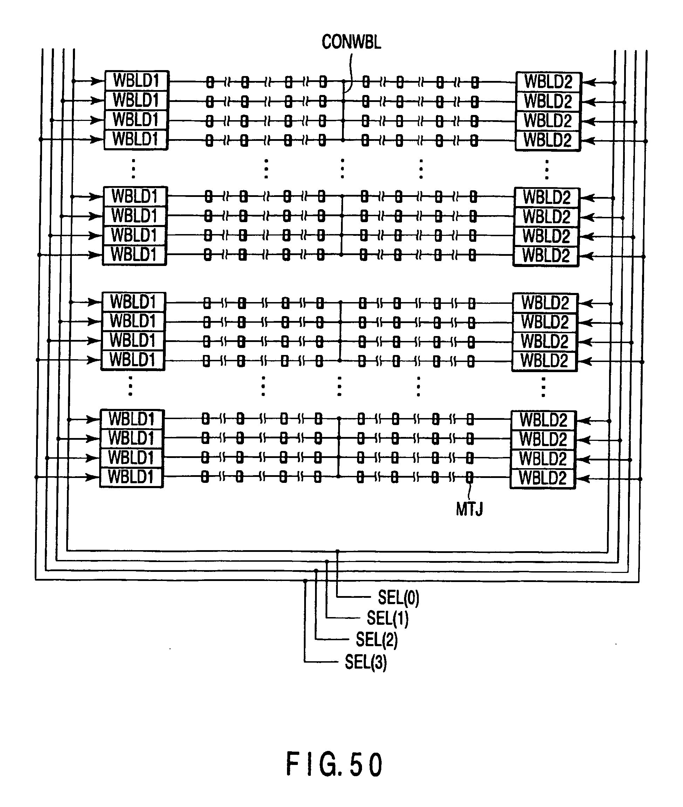

FIG. 50 is a diagram illustrating the address signal SEL(n). The address signal SEL(0) is supplied to the (uppermost) write bit line current circuits WBLD1 and WBLD2 with the smallest row address in each interconnected unit. The address signal SEL(0) indicates that these write bit line current circuits WBLD1 and WBLD2 are to be selected. Similarly, The address signal SEL(y) is supplied to the write bit line current circuits WBLD1 and WBLD2 with the y+1-th smallest row address in each interconnected unit (the y+1-th write bit line current circuits WBLD1 and WBLD2 from the top of the unit). The address signal SEL(y) indicates that these write bit line current circuits WBLD1 and WBLD2 are to be selected.

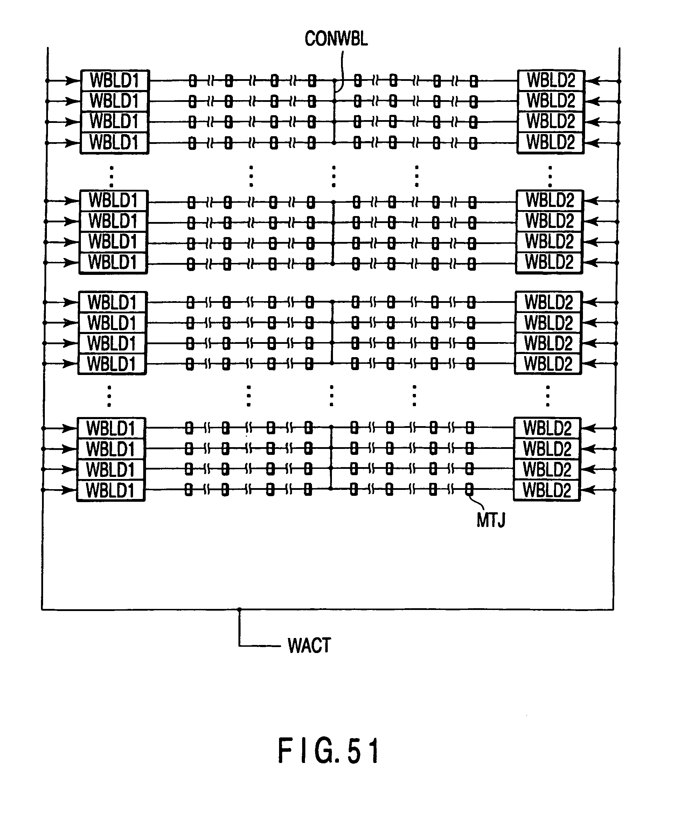

FIG. 51 is a diagram illustrating the signal WACT. The signal WACT is supplied to all the write bit line current circuits WBLD1 and WBLC2. The signal WACT indicates that the write bit line current circuit WBLD1 and WBLD2 are operative or inoperative.

In semiconductor memory device according to the first embodiment of the present invention, the numbers of drivers and sinkers included in write bit line current circuits of the configuration of the first embodiment during a write. Specifically, the drivers and sinkers connected to the write lines other than the selected ones (selected write bit line WBL and selected write word line WWL) are also activated depending on the direction of the write current. Thus, the write current passing through the selected MTJ elements is dispersed to other write lines. It is thus possible to conduct a write current larger than the one used in the prior art, through the write lines. In other words, a sufficient write current can be provided even if an increase in the length of the write lines results in an increase in the wiring resistance of the write lines.

Further, the total currents from the plurality of write lines flow into the selected write line. Consequently, even with an increase in the length of the write lines, a sufficient write current can be provided without applying a high voltage to the write lines.

### (Second Embodiment)

In a second embodiment, in addition to the control of the first embodiment, control is performed such that no current flows through that part of the write line adjacent to the selected one which is adjacent to the selected MTJ elements.

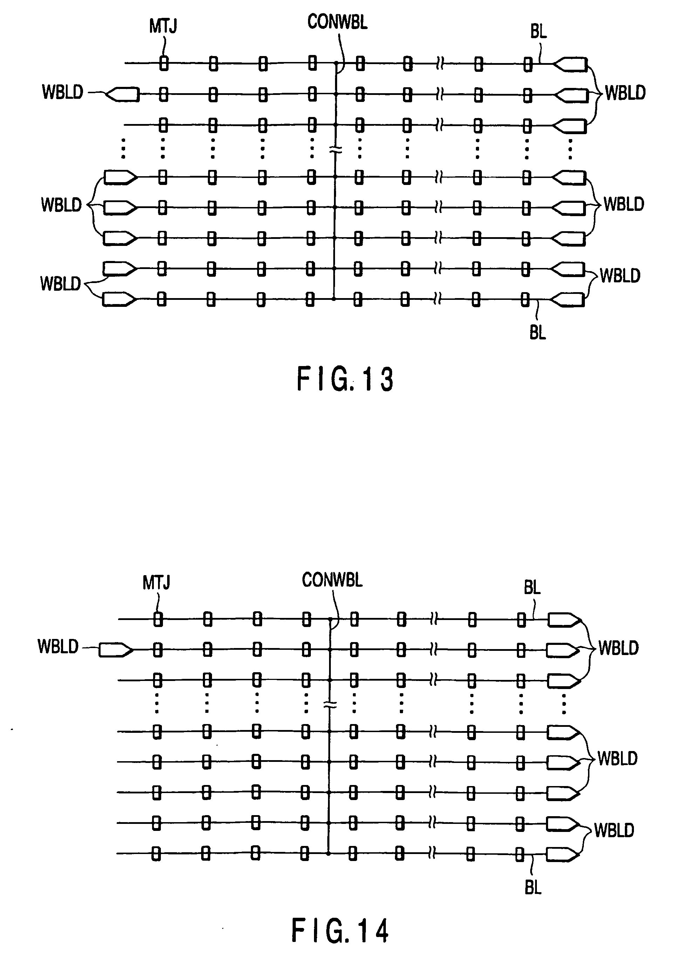

FIGS. 12 and 13 are each a diagram schematically showing a state of essential parts of a semiconductor memory device according to the second embodiment during a write. In FIG. 12, the write current flows rightward in the drawing through the selected write bit line WBL. The selected write bit line is the second one from the top of the drawing. FIG. 12 corresponds to the state of the first embodiment shown in FIG. 8. In FIG. 13, the write current flows through the selected write bit line WBL leftward in the drawing. FIG. 13 corresponds to the state of the first embodiment shown in FIG. 9.

As shown in FIG. 12, in one of the write bit line current circuits WBLD which is connected to the write bit line WBL (adjacent write bit line) adjacent to the selected one WBL and located on the same side of the unit as that on which the selected MTJ elements MTJ are arranged with respect to the connection line CONWBL, neither the driver nor the sinker operates. In the other write bit line current circuits WBLD, the sinker operates.

Further, as shown in FIG. 13, in one of the write bit line current circuits which is connected to the adjacent write bit line and located on the same side of the unit as that on which the selected MTJ elements MTJ are arranged with respect to the connection line CONWBL, neither the driver nor the sinker operates. In the other write bit line current circuits WBLD, the driver operates.

The control in FIGS. 12 and 13 prevents a current from flowing through that part of the adjacent write bit line WBL which is adjacent to the selected MTJ elements.

The semiconductor memory device according to the second embodiment of the present invention is not only configured as the first embodiment but also prevents the current from flowing through the part of the adjacent write bit line (adjacent write bit line WBL and adjacent write word line WWL) which is adjacent to the selected MTJ elements. Thus, the semiconductor memory device not only produces the same effects as those of the first embodiment but can also prevent the application, to the selected MTJ elements, of a magnetic field induced by a current flowing through that part of the adjacent write bit line which is adjacent to the selected MTJ elements. Therefore, miswrites to the MTJ elements can be avoided.

### (Third Embodiment)

In a third embodiment, the driver or sinker at only one end of each of the write lines (unselected write lines) other than the selected one operates depending on the positions of the selected MTJ elements.

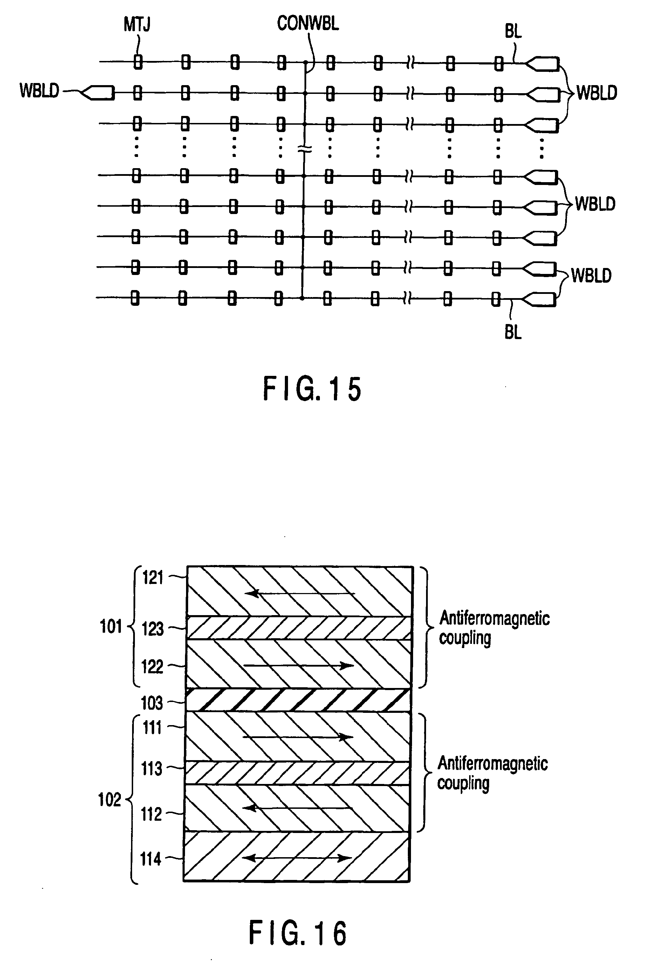

FIGS. 14 and 15 are each a diagram schematically showing a state of essential parts of a semiconductor memory device according to the third embodiment during a write. In FIG. 14, the write current flows rightward in the drawing through the selected write bit line WBL. The selected write bit line WBL is the second one from the top of the drawing. FIG. 14 corresponds to the state of the first embodiment shown in FIG. 8. In FIG. 15, the write current flows through the selected write bit line WBL leftward in the drawing. FIG. 15 corresponds to the state of the first embodiment shown in FIG. 9.

As shown in FIG. 14, none of the drivers and sinkers located to the left of the connection line CONWBL operate except that connected to the selected write bit line WBL. Only the driver connected to the selected write bit line WBL operates. All the sinkers located to the right of the connection line CONWBL operate.

Further, as shown in FIG. 15, none of the drivers and sinkers located to the left of the connection line CONWBL operate except that connected to the selected write bit line WBL. The sinker connected to the selected write bit line WBL is activated. All the drivers located to the right of the connection line CONWBL operate.

During a write, the write current flows through the selected write word line WWL. Accordingly, a magnetic field induced by the write current is also applied to the unselected MTJ elements MTJ belonging to the same columns as those of the selected MTJ elements MTJ. In this state, when the current flows through those parts of the write bit lines WBL (unselected write bit lines WBL) other than the selected one WBL which pass through the unselected MTJ elements MTJ to which the magnetic field from the selected write bit line WBL is applied, miswrites may be executed on the unselected MTJ elements MTJ. Thus, in the semiconductor memory device according to the third embodiment of the present invention, the drivers and sinkers located on the same side of the unit as that on which selected MTJ elements MTJ are arranged with respect to the connection line CONWBL do not operate except that connected to the selected write bit line WBL. This avoids applying a magnetic field from the write bit line WBL to the unselected MTJ elements MTJ located on the same side of the unit as that on which the selected MTJ elements MTJ are arranged, the selected write word line WWL passing through the unselected MTJ elements MTJ. Therefore, it is possible to sharply reduce the possibility of miswrites on the unselected MTJ elements MTJ.

The write bit line WBL has been described in conjunction with the example shown in FIG. 2. However, the examples shown in FIGS. 4 and 5 can be similarly controlled.

### (Fourth Embodiment)

A fourth embodiment relates to a semiconductor memory device employing what is called a toggle write system (toggle MRAM). The toggle MRAM is described in U.S. Patent No. 6,545,906B1 (Savtchenco et al.). The easy axis of magnetization of the MTJ elements MTJ in the toggle MRAM extends along a direction inclined at an angle of 45 deg. to the write bit lines and write word lines in a plane consisting of write bit lines and write word lines. The toggle MRAM differs from a conventional semiconductor memory device in the structure of the MTJ elements and a timing for conducting the write current.

First, description will be given of the semiconductor memory device employing the toggle write system. FIG. 16 is a sectional view schematically showing the structure of an MTJ element MTJ used in a toggle MRAM. In FIG. 16, the direction of magnetizations in a free layer and a pin layer are parallel (parallel state). As shown in FIG. 16, an insulating tunneling barrier layer 103 is sandwiched between a free layer 101 and a pin layer 102. The pin layer 102 has two ferromagnetic layers 111 and 112 consisting of ferromagnetic metal, a paramagnetic layer 113 sandwiched between the ferromagnetic layers 111 and 112 and consisting of paramagnetic metal, and an antiferromagnetic layer 114 consisting of antiferromagnetic metal. The structure consisting of the ferromagnetic layers 111 and 112 and the paramagnetic layer 113 is provided on the antiferromagnetic layer 114. The two ferromagnetic layers 111 and 112 are coupled in an antiferromagnetic manner.

The free layer 101 has two ferromagnetic layers 121 and 122 consisting of ferromagnetic metal and a paramagnetic layer 123 sandwiched between these ferromagnetic layers and consisting of paramagnetic metal. The two ferromagnetic layers 121 and 122 are coupled in an antiferromagnetic manner. In the parallel state, the direction of magnetizations of the two ferromagnetic layers 111 and 122, sandwiching the tunneling barrier layer 103 between them, are parallel.

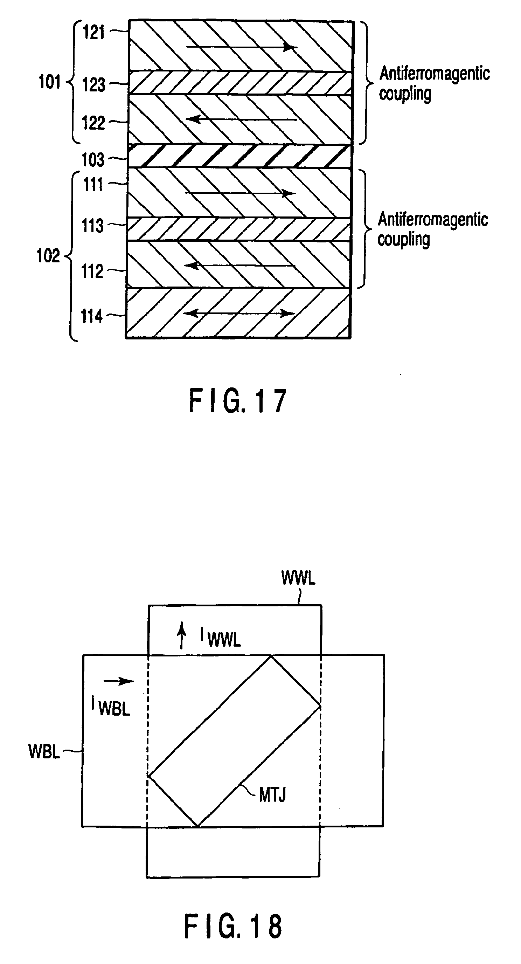

On the other hand, if the MTJ element MTJ is in an antiparallel state, the direction of magnetizations of the two ferromagnetic layers 111 and 122, sandwiching the tunneling barrier layer 103 between them, are antiparallel as shown in FIG. 17.

Now, a brief description will be given of a write method based on the toggle write system. If the toggle write system is employed, data is read from an MTJ element MTJ on which a write is to be executed. If the data read is the same as write data, no write is executed. A write is executed only when the data read is different from the write data.

With the toggle write system, a write changes the state of the MTJ element MTJ regardless of the state of the MTJ element MTJ prior to the write. For example, if the MTJ element MTJ is in an antiparallel state, a write brings the MTJ element MTJ into a parallel state. If the MTJ element MTJ is in the parallel state, a write brings the MTJ element MTJ into the antiparallel state.

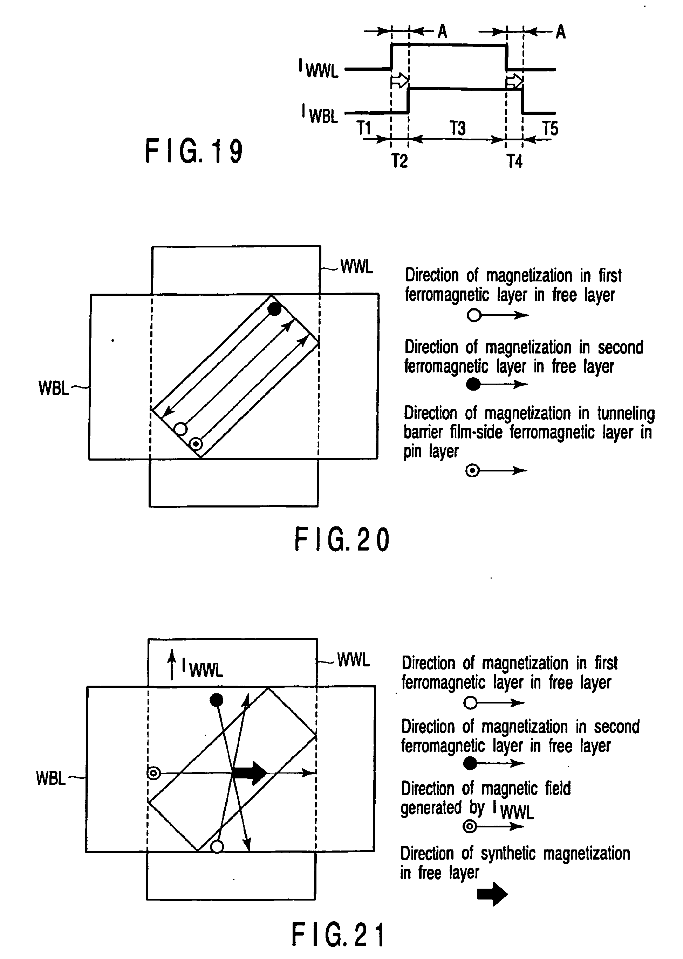

As shown in FIG. 18, IWWL is conducted through the write word line WWL and IWBL is conducted through the write bit line WBL to reverse the state of the MTJ element MTJ. Timings for providing the write currents IWWL and IWBL are as shown in FIG. 19. As shown in FIG. 19, there is a specific delay A between a timing for providing the write current IWWL and a timing for providing the write current IWBL.

Now, description will be given of the state of the MTJ element MTJ during periods T1 to T5 shown in the waveform diagram in FIG. 19. During a write operation described below, the direction of magnetization in the ferromagnetic layer of the pin layer remains unchanged.

### Period T1 (Initial State)

As shown in FIG. 20, the MTJ element MTJ is in the parallel state or antiparallel state depending on the directions of magnetizations in the two ferromagnetic layers located opposite each other across the tunneling barrier layer. Specifically, in FIGS. 20 to 24, each of the first ferromagnetic layer and the second ferromagnetic layer of the free layer corresponds to one of the ferromagnetic layers 122 and 111 in FIGS. 16 and 17.

If the direction of magnetization of the ferromagnetic layer 122 in FIGS. 16 and 17 corresponds to that of the first ferromagnetic layer in FIG. 20, the MTJ element MTJ is initially in the parallel state. On the other hand, if the direction of magnetization of the ferromagnetic layer 122 in FIGS. 16 and 17 corresponds to that of the second ferromagnetic layer in FIG. 20, the MTJ element MTJ is initially in the antiparallel state. The direction of magnetizations in the first and second ferromagnetic layers of the free layer are opposite to each other. Accordingly, a synthetic magnetization of the free layer is almost zero.

### Period 2 (Supply of IWWL)

As shown in FIG. 21, the write current IWWL through the write word line WWL induces a magnetic field. As s result, the direction of magnetizations in the first and second ferromagnetic layers of the free layer follow the direction of the magnetic field induced by the write current IWWL. Therefore, a synthetic direction of magnetization appears of the free layer.

Here, the direction of magnetizations in the two ferromagnetic layers are prevented from following the direction of the magnetic field induced by the write current IWWL, by adjustably designing the antiferromagnetic coupling of the two ferromagnetic layers of the free layer. The direction of magnetizations in the two ferromagnetic layers of the free layer spin clockwise while maintaining the antiferromagnetic coupling.
The magnetizations follow the magnetic field induced by the write current IWWL. Then, once the synthetic direction of magnetization of the free layer coincides with the direction of the magnetic field induced by the write current IWWL, the rotations of the direction of magnetizations of the two ferromagnetic layers of the free layer stops. In other words, the rotations make the synthetic direction of magnetization of the free layer parallel to the write bit line WBL.

### Period T3 (Supply of IWWL and IWBL)

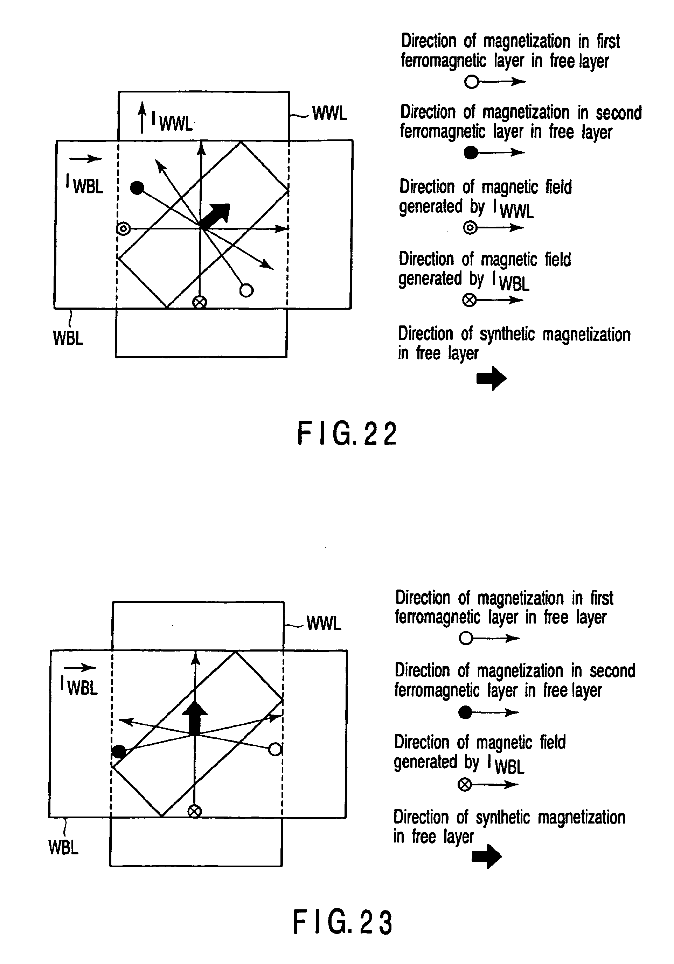

Then, as shown in FIG. 22, the write current IWBL flowing through the write bit line WBL with the write current IWWL passing through the write word line WWL induces a synthetic magnetic field. As a result, while maintaining the antiferromagnetic coupling, the direction of magnetizations in the two ferromagnetic layers of the free layer rotate until the synthetic direction of magnetization of the free layer coincides with the direction of the synthetic magnetic field induced by the write currents IWWL and IWBL. In other words, the rotations make the synthetic direction of magnetization of the free layer equal to the direction of the easy axis of magnetization of the MTJ element MTJ.

### Period T4 (Supply of IWBL)

Then, as shown in FIG. 23, the write current IWWL conducted through the write bit line WBL is blocked. Then, a magnetic field is induced only by the write current IWBL flowing through the write bit line WBL. As a result, while maintaining the antiferromagnetic coupling, the direction of magnetizations of the two ferromagnetic layers of the free layer rotate until the synthetic direction of magnetization of the free layer coincides with the direction of the synthetic magnetic field induced by the write current IWBL. In other words, the rotations make the synthetic direction of magnetization of the free layer parallel to the write word line WWL.

### Period T5 (Completion of the Write)

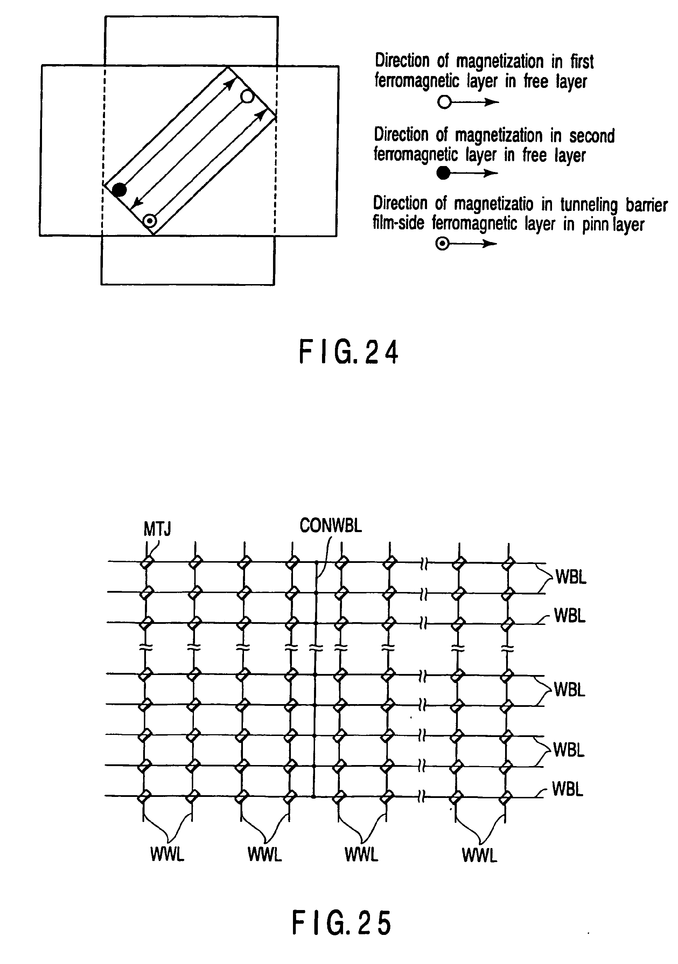

Then, as shown in FIG. 24, the write current IWBL conducted through the write bit line WBL is blocked. Then, while maintaining the antiferromagnetic coupling, the direction of magnetizations of the two ferromagnetic layers of the free layer rotate until they coincide with the direction of the easy axis of magnetization of the MTJ element MTJ.

The directions of magnetizations of the two ferromagnetic layers of the free layer have already rotated from the initial state at the period T4. Accordingly, energy is more stabilized when the directions of magnetizations are reversed than going back to the initial state. Therefore the directions of magnetizations keep rotating to be reversed even after the write current is blocked.

In the present example, as shown in FIG. 19, a current starts to be conducted through the write word line WWL the specific delay time A earlier than through the write bit line WBL. However, the opposite setting is possible, that is, a current may start to be conducted through the write bit line WBL the specific delay time A earlier than through the write bit line WBL. However, the opposite setting is possible, that is, a current may start to be conducted through the write bit line WBL the specific delay time A earlier than through the write word line WWL. In this case, the direction in which the direction of magnetizations rotate differ from that in the above example. However, as in the case of the above example, the direction of magnetizations of the two ferromagnetic layers of the free layer rotate so that the synthetic direction of magnetization of the free layer coincides with the direction of the magnetic field induced by the write word line WWL and write bit line WBL.

Now, description will be given of a fourth embodiment relating to a semiconductor memory device employing the toggle write system. FIG. 25 is a diagram schematically showing essential parts of the semiconductor memory device according to the fourth embodiment. As shown in FIG. 25, the easy axis of magnetization of the MTJ elements MTJ extends along a direction inclined at an angle of 45 deg. to the write bit lines and write word lines. Further, the MTJ element MTJ according to the present embodiment has a configuration suitable for the toggle write system, for example, as shown in FIG. 17. FIG. 25 shows an example in which the connection line CONWBL electrically connects the write bit lines WBL. FIG. 25 corresponds to FIG. 2. The remaining part of the configuration of the present embodiment is the same as that in FIG. 2.

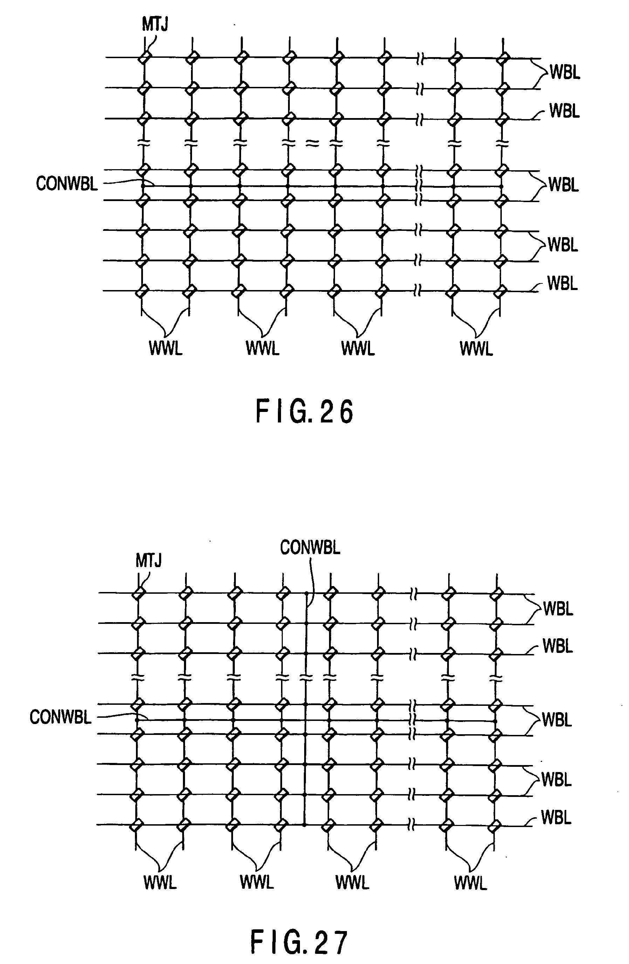

Further, as shown in FIG. 26, the connection line CONWWL may electrically connect the write word lines WWL. FIG. 26 corresponds to FIG. 4, showing the first embodiment, and is the same as FIG. 4 except for the configuration of the MTJ element MTJ and the direction of the easy axis of magnetization.

Moreover, as shown in FIG. 27, both connection lines CONWBL and CONWWL may be provided. FIG. 27 corresponds to FIG. 5, and is the same as FIG. 5 except for the configuration of the MTJ element MTJ and the direction of the easy axis of magnetization.

In the semiconductor memory device according to the fourth embodiment, the write lines are electrically connected together by the connection line regardless of the direction of the easy axis of magnetization of the MTJ elements MTJ. Therefore, the fourth embodiment has the same advantages as those of the first embodiment.

### (Fifth Embodiment)

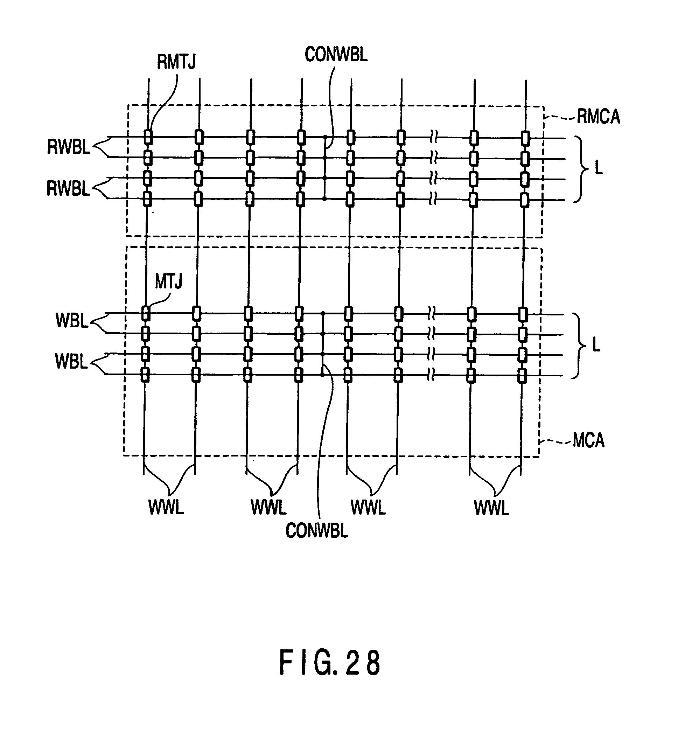

A fifth embodiment relates to the case in which a redundancy circuit is provided. FIG. 28 is a diagram schematically showing essential parts of the semiconductor memory device according to the fifth embodiment. As shown in FIG. 28, the semiconductor memory device has a memory cell array MCA configured in the same manner as in the first embodiment and a redundant memory cell array RMCA (for replacement). For example, for operation tests on the semiconductor memory device, an internal circuit is programmed using a program wiring section composed of a plurality of fuses or the like. The internal circuit allows switching to redundant MTJ elements MTJ in the redundant memory cell array MCA even if the address of a defective MTJ element MTJ or of a line containing such an MTJ element MTJ is input during actual use.

The configuration of the redundant memory cell array is similar to that of the memory cell array MCA. That is, redundant MTJ elements RMTJ are arranged in a matrix. Write bit lines RWBL and write word lines WWL for replacement cross so that the MTJ elements RMTJ constitute intersections. A connection line CONRWBL electrically connects the write bit lines RWBL. In this case, the number of write bit lines RWBL connected together by the connection line CONRWBL is set equal to that L of write bit lines WBL connected together by the connection line CONWBL in the memory cell array MCA.

When a defective MTJ element MTJ is to be replaced, the bit lines WBL connected together by one connection line CONWBL and the MTJ elements MTJ through which the bit lines WBL pass are used as a unit to replace the defective MTJ element MTJ with a write bit line RWBL and a redundant MTJ element RMTJ. Thus, even with the MTJ element MTJ is replaced with the redundant MTJ element RMTJ, the semiconductor memory device can be operated as in the case where replacement is not carried out. It is also possible to obtain the same advantages as those of the connection line in the memory cell array MCA.

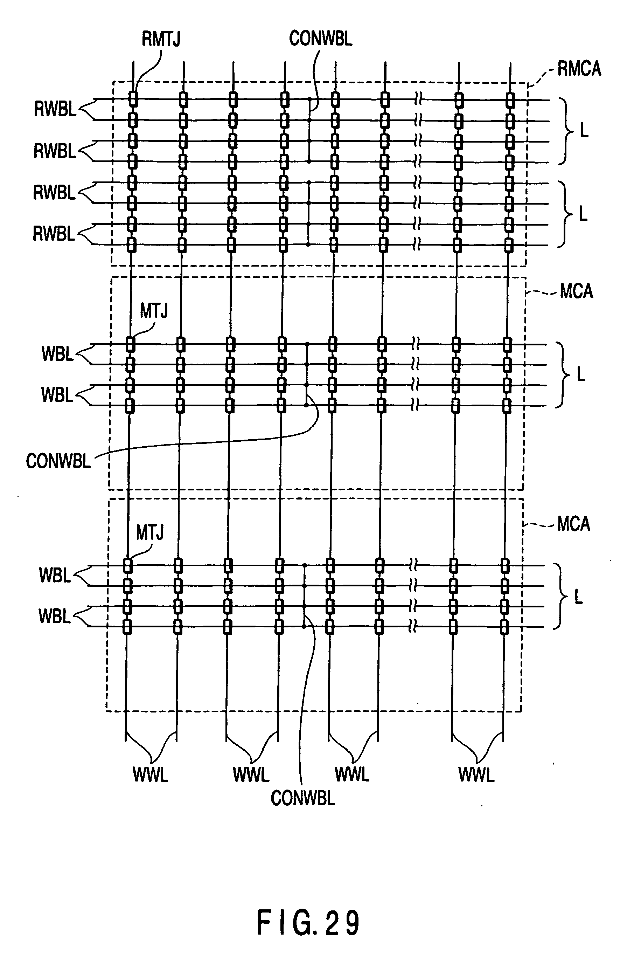

In the example in the above description, one redundant memory cell array RMCA is provided for one memory cell array MCA. However, the present invention is not limited to this. For example, as shown in FIG. 29, each of a plurality of units in one redundant memory cell array RMCA may be replaced with a plurality of memory cell arrays MCA.

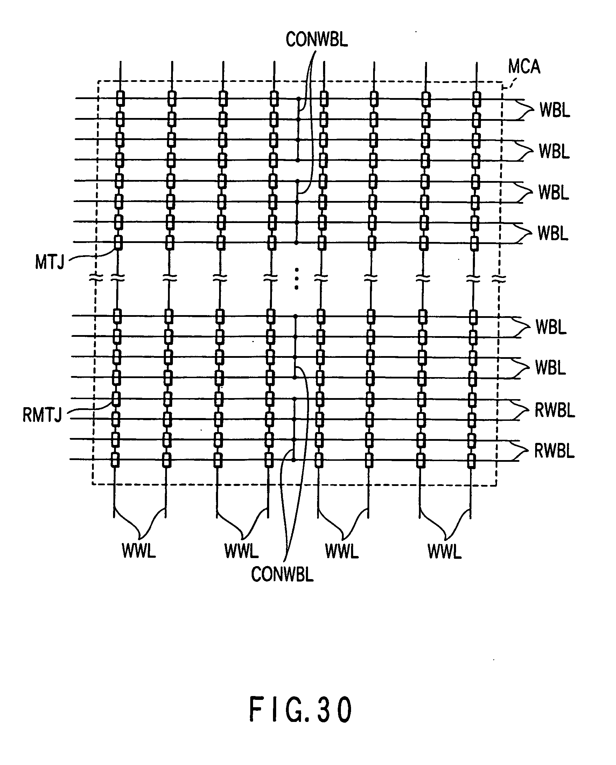

Further, in the example in the above description, the redundant memory cell array RMCA is provided in addition to the memory cell array MCA. However, a redundant memory cell portion may be provided in one memory cell array so that a defective memory cell can be replaced within the same memory array, for example, as shown in FIG. 30.

Moreover, fewer number of the write lines in one redundancy-replacement unit than that of the write lines connected together improves redundancy-based replacement efficiency.

In the semiconductor memory device according to the fifth embodiment of the present invention, a connection line electrically connects write lines in the memory cell array MCA, as in the case of the first mentioned arrangement. Thus, the same advantages are gained.

Further, according to the fifth embodiment, the connection line CONRWBL electrically connects the write bit lines RWBL in the memory cell array RMCA. The number of write bit lines RWBL connected together is the same as that of write bit lines WBL connected together in the memory cell array MCA. Thus, even if a defective site is replaced, the advantages of the connection line are not impaired.

### (Sixth Embodiment)

A sixth embodiment relates to a semiconductor memory device employing what is called resistance-divided memory cell. The resistance-divided cell is described in Jpn. Pat. Appln. KOKAI Publication 2002-382393. In a conventional semiconductor memory device, one memory cell has one MTJ element, and data is read using a current signal obtained by applying a specified voltage to the MTJ element or a voltage signal generated across the MTJ element by supplying a specified current to the MTJ element. In contrast, for the resistance-divided cell, one memory cell has two MTJ elements holding complementary data. Data is identified on the basis of the ratio of the resistance of one of the MTJ elements to that of the other MTJ element.

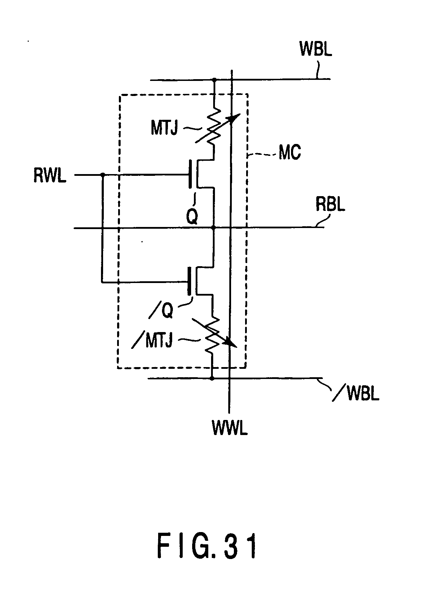

First, a brief description will be given of a semiconductor memory device employing a resistance-divided cell. FIG. 31 shows a resistance-divided cell. As shown in FIG. 31, one memory cell has two MTJ elements MTJ and /MTJ connected in series. Each of the MTJ elements has one end connected to a write bit line WBL or /WBL, respectively. On the other hand, the other ends of the MTJ elements are connected together via selection transistors Q and /Q. This connection node constitutes a read bit line RBL. A read word line RWL is connected to gates of the selection transistors Q and /Q.

Complementary data are stored in the MTJ elements MTJ and /MTJ. For example, when the MTJ element MTJ = "1" data and MTJ element /MTJ = "0", the memory cell stores "1". On the other hand, when the MTJ element MTJ = "0" data and MTJ element /MTJ = "1", the memory cell stores "0".

A write is executed by appropriately controlling the directions of currents through the write word lines WWL and write bit line WBL and /WBL so that the data in the MTJ elements MTJ and /MTJ are opposite to each other.

A read is executed by defining the resistances of the MTJ elements MTJ and /MTJ as R1 and R2, respectively, and reading a potential V R2/(R1+R2) generated in the read bit line RBL as a result of the application of a voltage V between the write bit lines WBL and /WBL. This potential is compared with a reference potential to determine the data held by the memory cell. Naturally enough, the resistances R1 and R2 is high of low depending on the data held in the MTJ elements MTJ and /MTJ.

Thus, the value for a read signal is not dependent on the absolute resistance of the MTJ element MTJ but is determined by the ratio of the resistance of one MTJ element to the resistance of another MTJ element. Accordingly, even if the resistance of the MTJ element varies owing to a variation in manufacturing process or the like, the absolute value of a read signal voltage does not vary. Therefore, a fixed read margin is ensured.

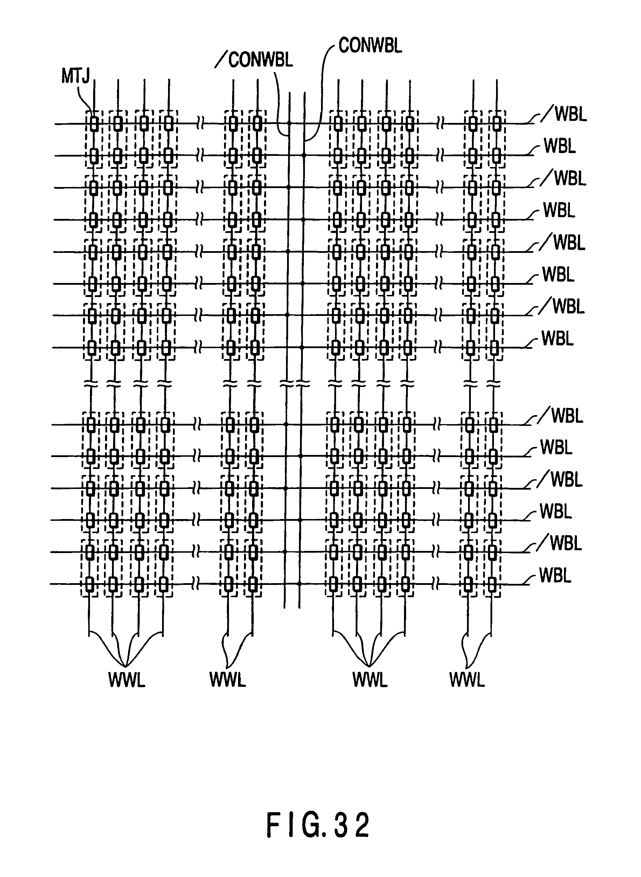

Now, description will be given of the sixth embodiment of the present invention relating to the semiconductor memory device employing the above resistance-divided cell. FIG. 32 is a diagram schematically showing essential parts of the semiconductor memory device according to the sixth embodiment of the present invention. As shown in FIG. 32, a plurality of write bit line pairs each consisting of write bit lines WBL and /WBL are provided. The positional relationship between the write bit lines WBL and /WBL is the same for all the bit line pairs. For example, the write bit line WBL is located closer to the top of the drawing, while the write bit line /WBL is located closer to the bottom of the drawing.

A resistance-divided memory cell MC is connected to between the bit lines of each pair. Each memory cell MC is placed on a matrix. The resistance-divided cell has two MTJ elements MTJ and /MTJ and two selection transistors Q and /Q (not shown) as in the case of the configuration shown in FIG. 31. Further, the connection node between the two MTJ elements MTJ and /MTJ is connected to the read bit line RBL. Each write word line WWL is provided so as to pass through the MTJ elements MTJ and /MTJ of the memory cells MC belonging to the same column.

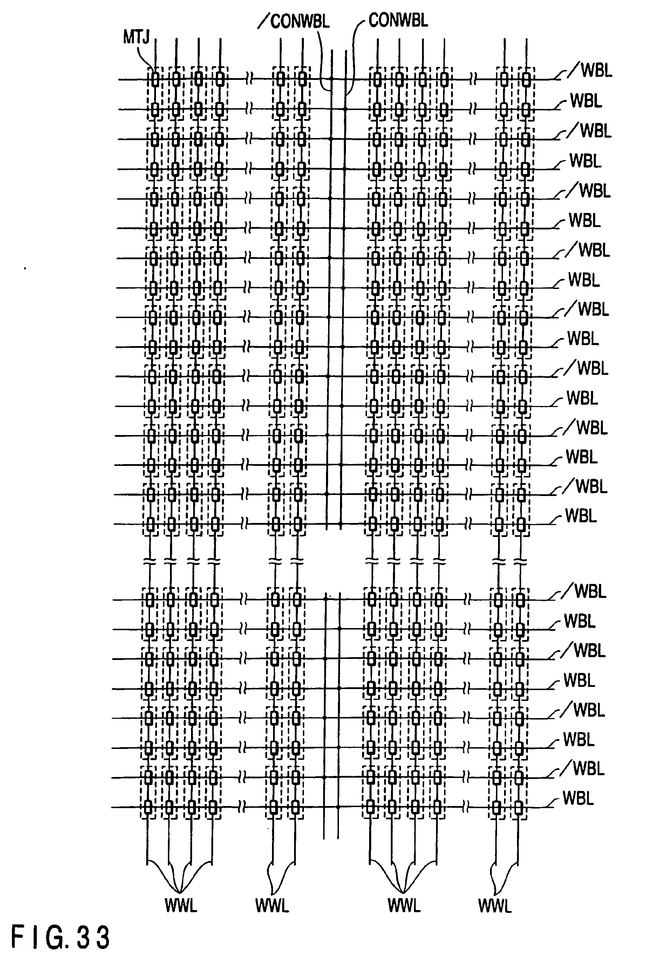

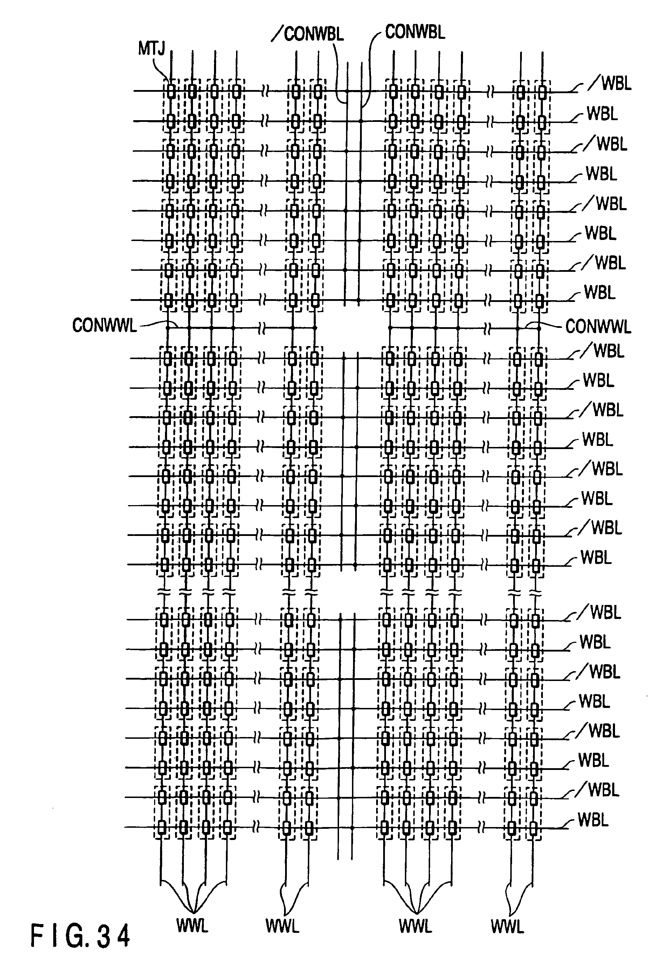

The write bit lines WBL are electrically connected together by the connection line CONWBL. The number of write bit lines WBL connected together may be arbitrary, for example, as shown in FIG. 33 (the figure illustrates four write bit lines WBL). Further, the write bit lines /WBL are electrically connected together by a connection line (second connection line) /CONWBL. The connection lines CONWBL and /CONWBL are typically located substantially in the center of the memory cell array MCA. Furthermore, as shown in FIG. 34, the write word lines WWL may be electrically connected together by the connection line CONWWL as in the case of FIG. 5. For example, in the present example, the connection line CONWBL is formed in the same layer as that of the write word lines WWL. The connection line CONWWL is formed in the same layer as that of the write bit lines WBL.

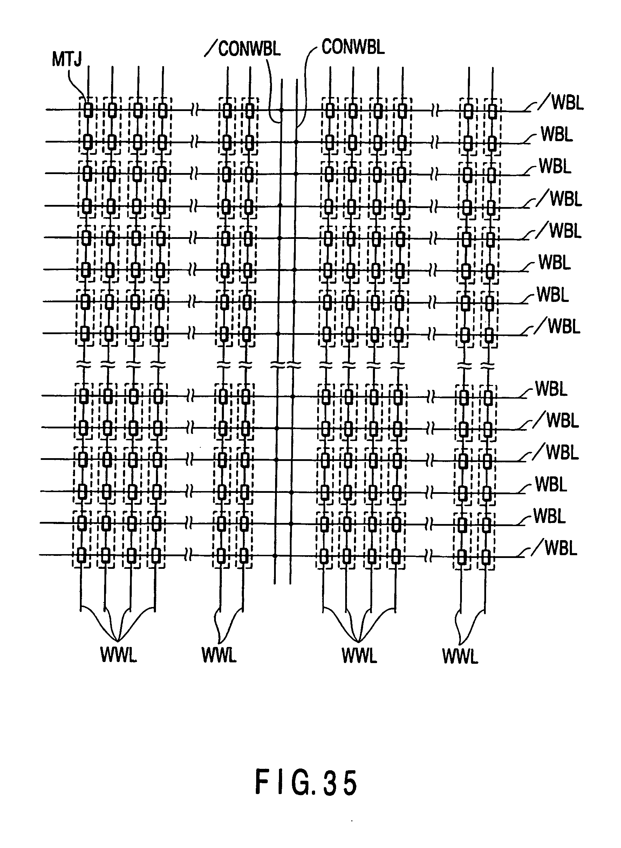

As shown in FIG. 35, the positional relationship between the write bit lines WBL and /WBL may be reversed between the adjacent write bit line pairs.

With the semiconductor memory device according to the sixth embodiment of the present invention, even with the resistance-divided memory cell, the same advantages as those of the first mentioned arrangement are gained by connecting the write bit lines WBL together and the write bit lines /WBL together.

### (Seventh Embodiment)

In the first to sixth embodiments, the write bit line current circuit WBLD is provided for each write bit line WBL and the write word line current circuit WWLD is provided for each write word line WWL. In contrast, in a seventh embodiment, the write bit line current circuit WBLD and the write word line current circuit WWLD are shared by a plurality of write bit lines WBL and a plurality of write word lines WWL, respectively. In the description below, most common examples of a write method and a memory cell configuration will be shown. However, of course, the seventh embodiment is applicable to the fourth embodiment (toggle write system) or the sixth embodiment (resistance-divided memory cell).

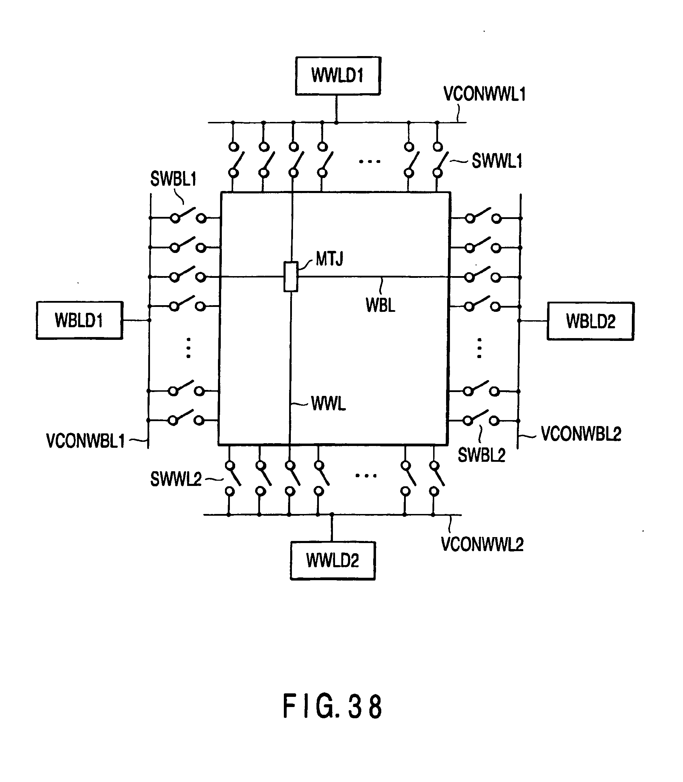

FIG. 38 is a diagram showing essential parts of a semiconductor memory device according to the seventh embodiment of the present invention. As shown in FIG. 38, one end of each write bit line WBL is connected to one end of a switch circuit SWBL1, for example, a transistor. The other end of each switch circuit SWBL1 is connected to a common line VCONWBL1. The common line VCONWBL1 is connected to the write bit line current circuit WBLD1.

Likewise, the other end of each write bit line WBL is connected to a common line VCONWBL2 via a switch circuit SWBL2, for example, a transistor. The common line VCONWBL2 is connected to the write bit line current circuit WBLD2.

One end of each write word line WWL is connected to one end of a switch circuit SWWL1, for example, a transistor. The other end of each switch circuit SWWL1 is connected to a common line VCONWWL1. The common line VCONWWL1 is connected to the write bit line current circuit WWLD1.

Likewise, the other end of each write word line WWL is connected to a common line VCONWWL2 via a switch circuit SWWL2, for example, a transistor. The common line VCONWWL2 is connected to the write word line current circuit WWLD2.

A current is supplied to a selected write bit line WBL or write word line WWL depending on whether the switch circuit SWBL1, SWBL2, SWWL1, or SWWL2 is turned on or off. A control circuit described later controls the turn-on and -off of the switch circuits SWBL1, SWBL2, SWWL1, and SWWL2. This control will be described later in detail.

The memory cell array is the same as that in the first mentioned arrangement, or fourth or sixth embodiments. Further, the interconnection lines CONWBL and CONWWL can take any form shown in the first arrangement. For example, one or both of the interconnection lines CONWBL and CONWWL may be provided.

FIG. 38 illustrates the case in which one memory cell array has one common line VCONWBL1, one common line VCONWBL2, one common line VCONWWL1, and one common line VCONWWL2. However, a plurality of common lines may be provided for each type. Alternatively, a plurality of memory cell arrays may be provided so that adjacent memory cell arrays share the common lines VCONWBL1, VCONWBL2, VCONWWL1, and VCONWWL2.

At standby, all the switch circuits SWBL1, SWBL2, SWWL1, and SWWL2 are on. Thus, the potential of the write bit line WBL is precharged to that of the connection lines VCONWBL1 and VCONWBL2 (typically the common potential). Further, the potential of the write word line WWL is precharged to that of the connection lines VCONWWL1 and VCONWWL2 (typically the common potential). As described later, during a write, the predetermined switch circuit SWBL1, SWBL2, SWWL1, or SWWL2 is turned off.

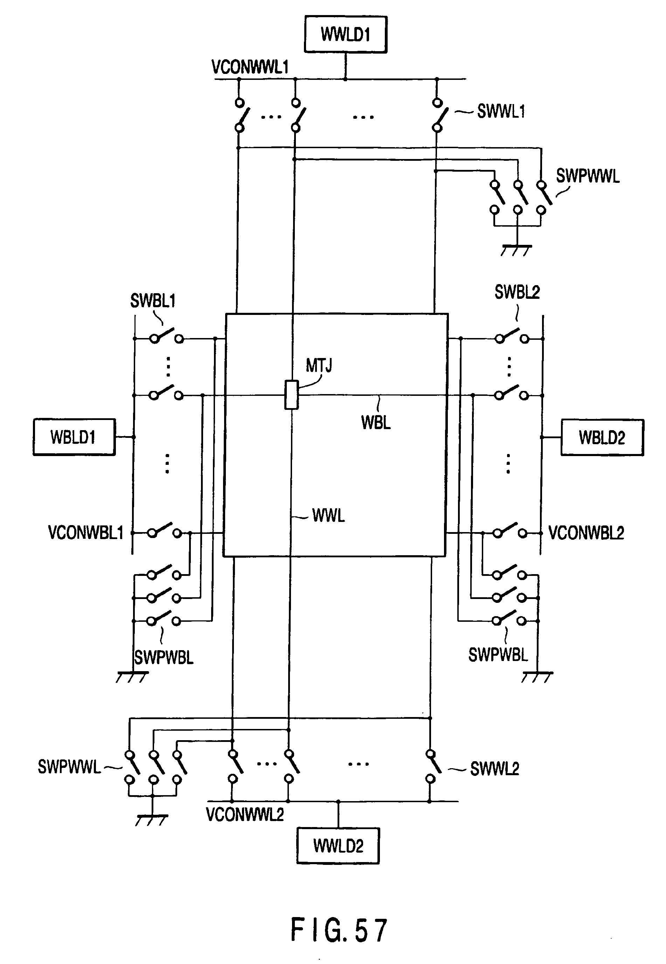

The write bit line WBL and the write word line WWL may be precharged at standby as follows. As shown in FIG. 57, a switch circuit SWPWBL, for example, a transistor, is provided between a common potential line and one end of each write bit line WBL (the connection node formed with the switch circuits SWBL1 and SWBL2). Likewise, a switch circuit SWPWWL, for example, a transistor, is provided between the common potential line and the other end of each write word line WWL (the connection node formed with the switch circuits SWWL1 and SWWL2). Then, the switch circuits SWPWBL and SWPWWL are on during standby and off during a write.

Now, the circuit in FIG. 38 will be described in further detail. The description below relates only to the write bit line WBL and the write bit line current circuits WBLD1 and WBLD2. However, the same description also applies to the write word line WWL and the write word line current circuits WWLD1 and WWLD2.

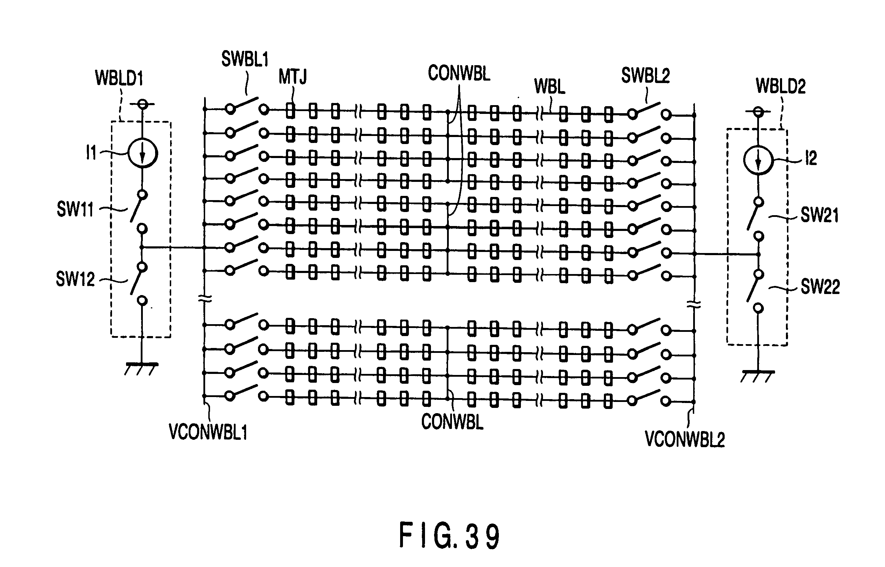

First, the write bit line current circuits WBLD1 and WBLD2 will be described with reference to FIGS. 39 to 41. FIGS. 39 to 41 are diagrams showing a part of the semiconductor memory device in FIG. 38 in detail. FIGS. 39 to 41 illustrate the case in which four write bit lines WBL are connected together by the connection line CONWBL.

In FIG. 39, the write current flows through the write bit line WBL in both directions. As shown in FIG. 39, the write bit line current circuit WBLD1 is composed of a current source 11 and switch circuits SW11 and SW12 connected in series between a power supply potential terminal and a common potential terminal. The write bit line current circuit WBLD2 is composed of a current source 12 and switch circuits SW21 and SW22 connected in series between the power supply potential terminal and the common potential terminal. The connection node between the switch circuits SW11 and SW12 is connected to the connection line VCONWBL1. The connection node between the switch circuits SW21 and SW22 is connected to the connection line VCONWBL2.

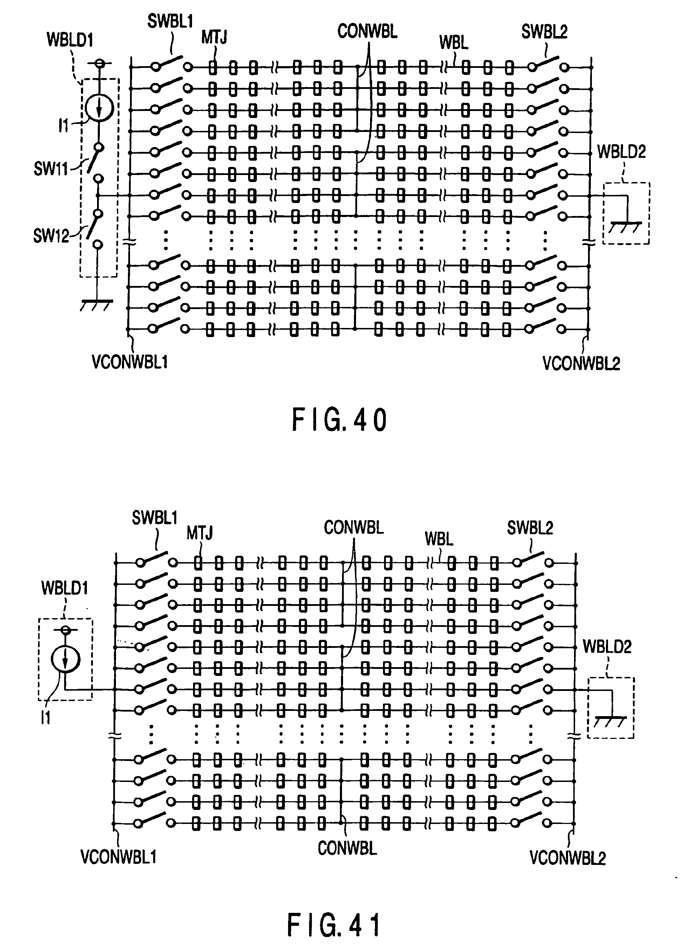

In FIGS. 40 and 41, the write current flows through the write bit line WBL in one direction. With a typical write method, the current needs not flow in both directions in either the write bit line WBL or write word line WWL. With the toggle write system, it is sufficient that the current flows in only one direction is both write bit line WBL and write word line WWL. In this case, it is possible to use a write current circuit of the configuration shown in FIGS. 40 and 41.

As shown in FIGS. 40 and 41, the part corresponding to the write bit line current circuit WBLD2 is not provided. The connection line VCONWBL2 is simply connected to the common potential terminal. In FIG. 40, the write bit line current circuit WBLD1 is the same as that shown in FIG. 39. In FIG. 41, the write bit line current circuit WBLD1 has only the current source 11, connected to the connection line VCONWBL1.

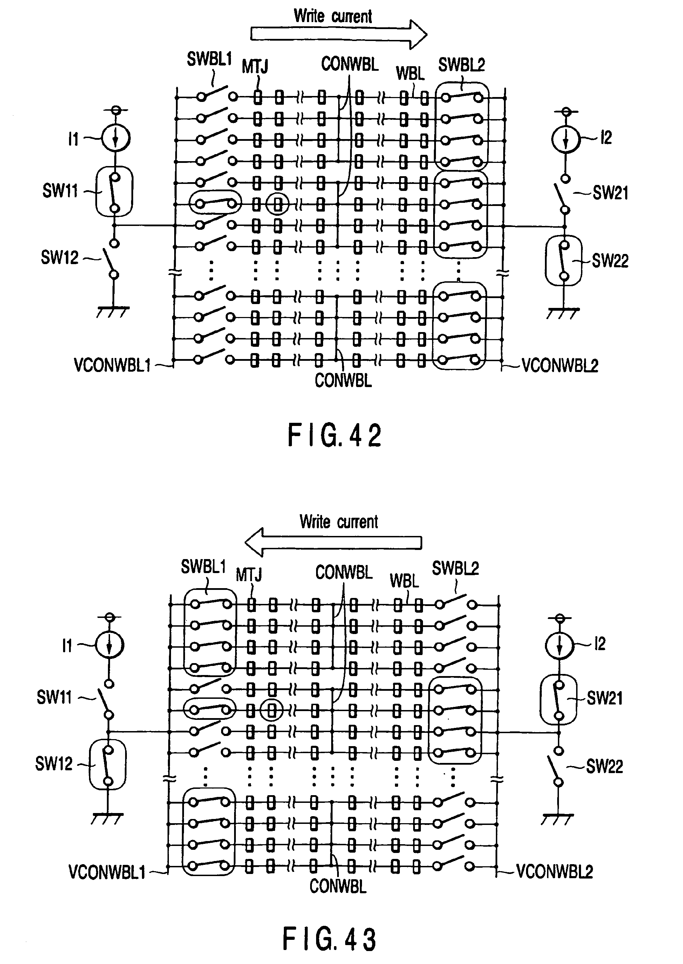

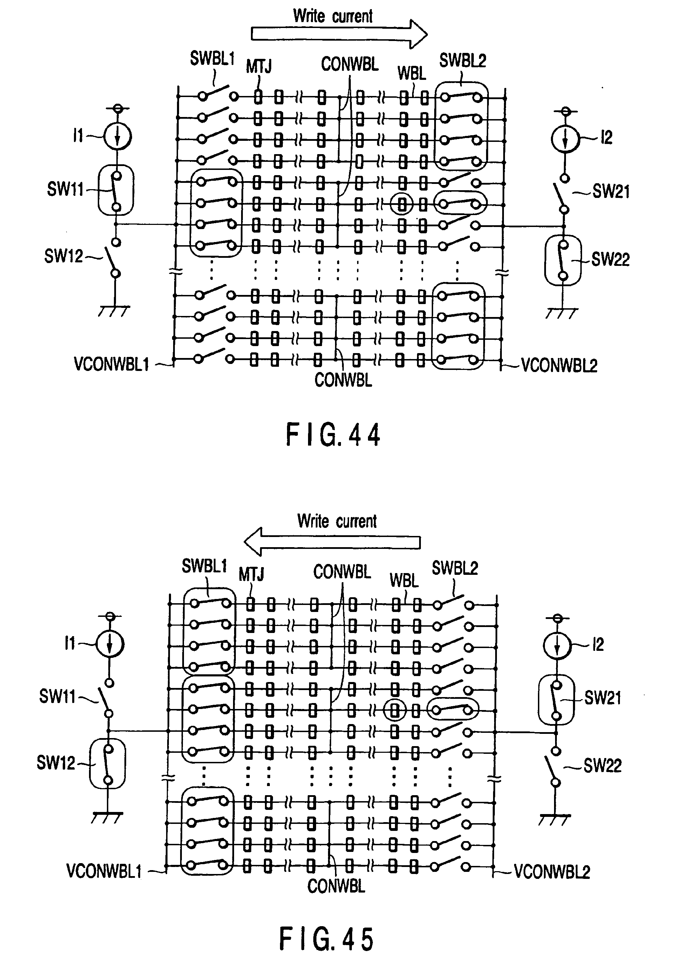

Now, with reference to FIGS. 42 to 45, description will be given of the control of the switch circuits SWBL1 and SWBL2 during a write. In FIGS. 42 to 45, in the second interconnected unit from the top, a write is executed on the MTJ elements MTJ (shown by circle) through which the second write bit line WBL from the top of the unit passes. In FIGS. 42 and 43, the selected MTJ elements MTJ are located to the left of the connection line CONWBL in the drawings. In FIGS. 44 and 45, the selected MTJ elements MTJ are located to the right of the connection line CONWBL in the drawings. Moreover, in FIGS. 42 and 44, the write current flows from the left to right of the drawings (for example, a write of "1"). In FIGS. 43 and 45, the write current flows from the right to left of the drawings (for example, a write of "0").

In FIG. 42, the switches SW11 and SW22 (shown by circle) are turned on. Further, only one of switches SWBL1 which is connected to the selected write bit line WBL is turned on. All the switches SWBL2 are turned on.

In FIG. 43, the switches SW12 and SW21 are turned on. Further, all the switches SWBL1 connected to the interconnection units (unselected interconnected units) other than those (selected interconnected units) containing the selected MTJ elements MTJ are turned on. All the switches SWBL2 connected to the unselected interconnected units remain off. For the switches SWBL1 and SWBL2 connected to the selected interconnected units, the switch SWBL1 connected to the selected bit line WBL and all the switches SWBL2 are on.

In FIG. 44, the switches SW11 and SW22 are turned on. Further, all the switches SWBL2 connected to the unselected interconnected units are turned on. All the switches SWBL1 connected to the unselected interconnected units remain off. For the switches SWBL1 and SWBL2 connected to the selected interconnected units, the switch SWBL2 connected to the selected bit line WBL and all the switches SWBL1 are on.

In FIG. 45, the switches SW12 and SW21 are turned on. Further, only one of switches SWBL2 which is connected to the selected write bit line WBL is turned on. All the switches SWBL1 are turned on.

If the current flows through the write bit line WBL in only one direction suffices, then for example, in FIGS. 42 and 44, the switches SW11 and SW22 may be always on. In this case, the write bit line current circuits WBLD1 and WBLD2 are configured in the same manner as in FIG. 40 or 41.

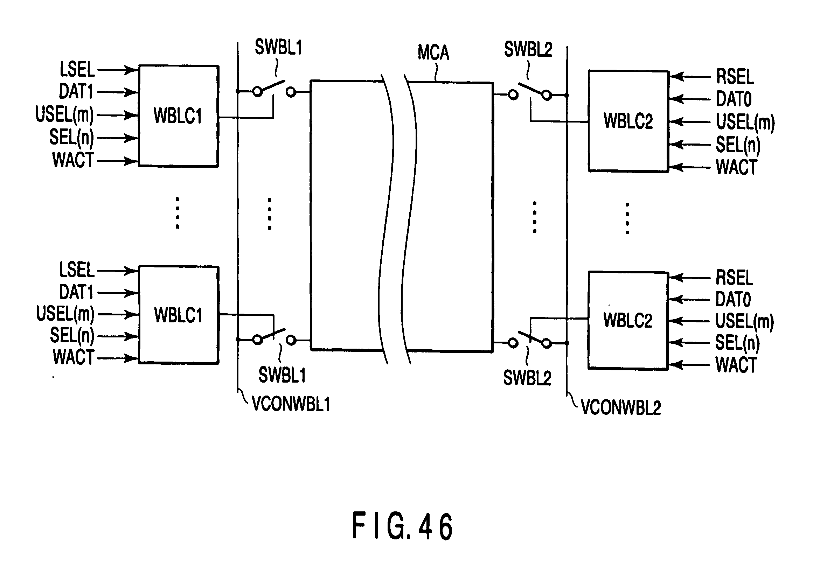

As shown in FIG. 46, each switch circuit SWBL1 is controlled by a write bit line write control circuit WBLC1. Each switch circuit SWBL2 is controlled by a write bit line write control circuit WBLC2. Each write bit line write control circuit WBLC1 is supplied with control signals LSEL, DAT1, and WACT, and address signals USEL(m) and SEL(n).

Each write bit line write control circuit WBLC2 is supplied with control signals RSEL, DAT0, and WACT, and the address signals USEL(m) and SEL(n). These control and address signals are the same as those in the second embodiment. Each of the switch circuits SWBL1 and SWBL2 is controlled in accordance with a combination of the control signals LSEL, RSEL, DAT0, DAT1, USEL(m), SEL(n), and WACT. As a result, in accordance with the positions of the selected MTJ elements, the positions of the selected MTJ elements with respect to the connection line CONWBL, and write data, a state similar to the one shown in any of FIGS. 42 to 45 is formed, with a magnetic field applied to the selected MTJ elements.

In the semiconductor memory device according to the seventh embodiment of the present invention, the write bit lines WBL are connected together and/or the write word lines WWL are connected together, as in the case of the first embodiment. Thus, the same effects as those of the first arrangement are produced.

Further, according to the seventh embodiment, the write bit lines WBL share the write bit line current circuits WBLD1 and WBLD2. The write bit lines WWL share the write word line current circuits WWLD1 and WWLD2. This serves to reduce the required numbers of write bit line current circuits WBLD1 and WBLD2 and write word line current circuit WWLD1 and WWLD2.

## Claims

1. A semiconductor memory device comprising:
a plurality of memory cells using a current flowing through a wiring (MTJ);
a plurality of first write lines (WBL) electrically or magnetically or electrically and magnetically connected to the memory cells and provided along a first direction; and
a first connection line (CONWBL) which electrically connects a first one of the first write lines with a second one of the first write lines, **characterized in that:**
each of the first write lines has a first end and a second end, the first ends being disposed to one side of the first connection line and the second ends being disposed to the other side of the first connection line, wherein each of said first one and second one of the first write lines is coupled to at least one memory cell between the first end and the first connection line (CONWBL) and is coupled to at least another memony all between the first conection line (CON WBL) and the second end, the semi conductor memory device further comprising a write circuit adapted to genenate during a write operation a write current wherein;
the write current in a write operation flows into the first end of the first one of the first write lines (WBL) connected by the first connection line (CONWBL) to the second one of the first write lines, and the write current flows out of the second end of the first one of the first write lines and out of at least one of the first and second ends of the second one of the first write lines, or
the write current flows into the first end of the first one of the first write lines (WBL) and into at least the first end of the second one of the first write lines connected by the first connection line to the first one of the first write lines, and the write current flows out of the second end of the first one of the first write lines (WBL).

2. The device according to claim 1, **characterized in that** the first connection line (CONWBL) is formed in a same wiring layer as that of the first write lines (WBL).

3. The device according to claim 1, **characterized in that** the first connection line (CONWBL) is placed in a central portion of the first write lines (WBL).

4. The device according to claim 1, **characterized in that** the number of memory cells (MTJ) electrically or magnetically or electrically and magnetically connected to one of the first write lines (WBL) is equal on opposite sides of the first connection line (CONWBL).

5. The device according to claim 1, **characterized in that** the first connection line (CONWBL) electrically connects n-th power of 2 (n is a natural number) first write lines (WBL) to each other.

6. The device according to claim 1, **characterized in that** the number of the first write lines (WBL) electrically connected by the first connection line (CONWBL) is at least the number of the first write lines which are included within a redundancy replacement unit.

7. The device according to claim 1, **characterized by** further comprising:
a plurality of redundant memory cells (RMTJ) to replace defective memory cell;
a plurality of redundant write lines (RWBL) electrically or magnetically or electrically and magnetically connected to the redundant memory cells and provided along the first direction; and
a redundant connection line (CONWBL) which electrically connects at least two of the redundant write lines each other, the number of the first write lines electrically connected each other is at least the number of the redundant write lines electrically connected each other.

8. The device according to claim 1, **characterized in that** the memory cells (MTJ) include magnetoresistance elements,
the magnetoresistance elements are periodically arranged, and
a distance (La) between the magnetoresistance elements within the memory cell adjacent to the first connection line (CONWBL) and the first connection line is larger than a spacing (Lb) between the periodically arranged magnetoresistance elements.

9. The device according to claim 1, **characterized by** further comprising:
a plurality of second write lines (WWL) electrically or magnetically or electrically and magnetically connected to the memory cells (MTJ) and provided along a second direction different from the first direction; and
a second connection line (CONWWL) which electrically connects at least two of the second write lines each other.

10. The device according to claim 9, **characterized in that** one of the memory cells (MTJ) is placed at an intersection between one of the first write lines (WBL) and one of the second write lines (WWL),
said one of the first write lines is formed in a wiring layer above said one of the memory cells, and said one of the second write lines is formed in a wiring layer below said one of the memory cells.

11. The device according to claim 9, **characterized in that** the number of the first write lines (WBL) electrically connected each other is at least the number of the second write lines (WWL) electrically connected each other.

12. The device according to claim 9, **characterized in that** the number of the memory cells (MTJ) electrically or magnetically or electrically and magnetically connected each other is at most the number of the memory cells electrically or magnetically or electrically and magnetically connected each other.

13. The device according to claim 1, **characterized in that** adjacent two of the first write lines constitute a first write line pair (WBL, /WBL),
a plurality of the first write line pairs are arranged,
the first connection line (CONWBL) electrically connects a plurality of the first write lines constituting one of the first write lines of the first write line pair each other, and
a second connection line (/CONWBL) electrically connects a plurality of the first write lines constituting another first write line of the first write line pair each other.

14. The device according to claim 1, **characterized in that** a first write circuit (WBLD) is connected to one end of the first write lines,
a second write circuit (WBLD) is connected to another end of the first write lines,
the first write circuit includes a current source circuit which supplies a write current to the first write lines and the second write circuit includes a current sink circuit that draws a write current out of the first write lines, or the first write circuits and the second write circuits include the current source circuit and the current sink circuit, and
the number of the current source circuits activated during one write operation is different from the number of the current sink circuits activated during one write operation.

15. The device according to claim 14, **characterized in that** a plurality of the first write lines (WBL) electrically connected each other constitute a first write line group, and
during one write operation, of the first write circuits (WBLD) and the second write circuits (WBLD) which are connected to the first write line group, one of the current source circuits and a plurality of the current sink circuits are activated or one of the current sink circuits and a plurality of the current source circuits are activated.

16. The device according to claim 14, **characterized in that** a plurality of the first write lines (WBL) electrically connected each other constitute a first write line group, and
during one write operation, of the first write circuits and the second write circuits which are connected to the first write line group,
when one of the current source circuits and a plurality of the current sink circuits are activated, the first write circuit or second write circuit adjacent to the current source circuit activated is inactivated, and
when one of the current sink circuits and a plurality of the current source circuits operate, the first write circuit or second write circuit adjacent to the current sink circuit operated is inactivated.

17. The device according to claim 14, **characterized in that** a plurality of the first write lines (WBL) electrically connected each other constitute a first write line group, and
during one write operation, of a plurality of the first write circuits and a plurality of the second write circuits which are located on a side of the device on which a write target memory cell is located with respect to the first connection line,
all the first write circuits and the second write circuits other than those connected to the first write line electrically or magnetically or electrically and magnetically connected to the write target memory cell are inactivated.

18. The device according to claim 14, **characterized in that** a plurality of the first write lines (WBL) electrically connected each other constitute a plurality of first write line groups, and
all the first write lines of at least one of the first write line groups not including the first write line electrically or magnetically or electrically and magnetically connected to a write target memory cell is precharged to a same potential.

19. The device according to claim 14, **characterized in that** a plurality of the first write lines (WBL) electrically connected each other constitute a first write line group,
the memory cells (MTJ) constitute a memory cell array, a plurality of the first write circuits are controlled by a first address signal for selecting the memory cell located on one side of the memory cell array with respect to the first connection line,
a plurality of the second write circuits are controlled by a second address signal for selecting the memory cell located on another side of the memory cell array with respect to the first connection line, and
the first address signal and the second address signal are complementary.

20. The device according to claim 14, **characterized in that** a plurality of the first write lines (WBL) electrically connected each other constitute a first write line group,
a plurality of the first write circuits are controlled by a first write data polarity signal indicating that data with a first polarity is to be written to the memory cell,
a plurality of the second write circuits are controlled by a second write data polarity signal indicating that data with a second polarity is to be written to the memory cell, and
the first write data polarity signal and the second write data polarity signal are complementary.

21. The device according to claim 14, **characterized in that** a plurality of the first write lines (WBL) electrically connected each other constitute a plurality of first write line groups,
the first write line groups are composed of a same number of the first write lines, and
one of a plurality of the first write circuits and one of a plurality of the second write circuits connected to one of the first write lines of the first write line groups are controlled by a same address signal.

22. The device according to claim 14, **characterized in that** a write operation control signal is supplied to the first write circuits and the second write circuits to control a timing for start or end or start and end of a write operation.

23. The device according to claim 1, **characterized in that** one end of the first write lines is electrically connected to a first common line (VCONWBL1) via a first switch circuit (SWBL1),
another end of the first write lines is electrically connected to a second common line (VCONWBL2) via a second switch circuit (SWBL2),
a first write circuit (WBLD1) is connected to the first common line,
a second write circuit (WBLD2) is connected to the second common line,
the first write circuit includes a current source circuit which supplies a write current to the first common line and the second write circuit includes a current sink circuit which draws a write current out of the second common line, or the first write circuit and the second write circuit include the current source circuit and the current sink circuit, and
the number of the first switch circuit on is different from that of the second switch circuit on during one write operation.

24. The device according to claim 23, **characterized in that** a plurality of the first write lines (WBL) electrically connected each other constitute a first write line group, and
during one write operation, of a plurality of the first switch circuits and a plurality of the second switch circuits which are connected to the first write line group, one of the first switch circuits and a plurality of the second switch circuits are on, or one of the second switch circuits and a plurality of the first switch circuits are on.

25. The device according to claim 23, **characterized in that** a plurality of the first write lines (WBL) electrically connected each other constitute a first write line group,
a plurality of the first write line groups are arranged,
of the first switch circuits and second switch circuits connected to at least one of the first write line groups not including the first write line electrically or magnetically or electrically and magnetically connected to a write target memory cell,
all the first switch circuits are off and a plurality of the second switch circuits are on, and all the second switch circuits are off and a plurality of the first switch circuits are on.

26. The device according to claim 23, **characterized in that** a plurality of the first write lines (WBL) electrically connected each other constitute a first write line group, and
all the first write lines of at least one of the first write line groups not including the first write line electrically or magnetically or electrically and magnetically connected to a write target memory cell is precharged to a same potential.

27. The device according to claim 23, **characterized in that** a plurality of the first write lines (WBL) electrically connected each other constitute a first write line group,
the memory cells (MTJ) constitute a memory cell array,
a plurality of the first switch circuits are controlled by a first address signal (LSEL) for selecting the memory cell located on one side of the memory cell array with respect to the first connection line,
a plurality of the second switch circuits are controlled by a second address signal (RSEL) for selecting the memory cell located on another side of the memory cell array with respect to the first connection line, and
the first address signal and the second address signal are complementary to each other.

28. The device according to claim 23, **characterized in that** a plurality of the first write lines (WBL) electrically connected each other constitute a first write line group,
a plurality of the first switch circuits are controlled by a first write data polarity signal (DATO) indicating that data with a first polarity is to be written to the memory cell,
a plurality of the second switch circuits are controlled by a second write data polarity signal (DAT1) indicating that data with a second polarity is to be written to the memory cell, and
the first write data polarity signal and the second write data polarity signal are complementary to each other.

29. The device according to claim 23, **characterized in that** a plurality of the first write lines (WBL) electrically connected each other constitute a plurality of first write line groups,
the first write line groups are composed of a same number of the first write lines, and
one of a plurality of the first switch circuits and one of a plurality of the second switch circuits connected to one of the first write lines of the first write line groups are controlled by a same address signal (SEL(n)).

30. The device according to claim 23, **characterized in that** a write operation control signal (WACT) is supplied to the first switch circuits and the second switch circuits to control a timing for start or end or start and end of a write operation.

31. The device according to claim 23, **characterized by** further comprising a third switch circuit (SWPWBL) connected between one of the plurality of first write lines and a first potential line.

## Patentansprüche

1. Halbleiterspeichergerät, umfassend:
eine Vielzahl von Speicherzellen, die eine Spannung verwenden, die durch eine Verkabelung (MTJ) fließt,
eine Vielzahl von ersten Schreibleitungen (WBL), die elektrisch oder magnetisch, oder elektrisch und magnetisch zu den Speicherzellen verbunden sind und entlang einer ersten Richtung bereitgestellt werden; und
eine erste Verbindungsleitung (CONWBL), welche elektrisch eine erste der ersten Schreibleitungen und eine zweite der ersten Schreibleitungen verbindet, **dadurch gekennzeichnet, dass**:
jede der ersten Schreibleitungen ein erstes Ende und ein zweites Ende aufweist, wobei das erste Ende an einer Seite der ersten Verbindungsleitung angeordnet ist und das zweite Ende an der anderen Seite der ersten Verbindungsleitung angeordnet ist, wobei jede der ersten und zweiten der ersten Verbindungsleitungen zu mindestens einer Speicherzelle gekoppelt ist zwischen dem erstem Ende und der ersten Verbindungsleitung (CONWBL) und zu mindestens der anderen Speicherzelle gekoppelt ist zwischen der ersten Verbindungsleitung (CONWBL) und dem zweiten Ende, wobei das Halbleiterspeichergerät ferner umfasst:
eine Schreibschaltung, die ausgebildet ist, um während einer Schreiboperation eine Schreibspannung zu erzeugen, wobei
die Schreibspannung in einer Schreiboperation in das erste Ende des ersten der ersten Schreibleitungen (WBL) fließt, die durch die erste Verbindungsleitung (CONWBL) zu der zweiten der ersten Schreibleitungen verbunden ist, und wobei die Schreibspannung aus dem zweiten Ende der ersten der ersten Schreibleitungen fließt und aus mindestens einem der ersten und zweiten Enden der zweiten der ersten Schreibleitungen, oder
die Schreibspannung in ein erstes Ende der ersten der ersten Schreibleitungen (WBL) fließt und in mindestens das erste Ende der zweiten der ersten Schreibleitungen, die durch die erste Verbindungsleitung zu der ersten der ersten Schreibleitungen verbunden ist, und wobei die Schreibspannung aus dem zweiten Ende der ersten der ersten Schreibleitungen (WBL) fließt.

2. Gerät nach Anspruch 1, **dadurch gekennzeichnet, dass** die erste Verbindungsleitung (CONWBL) in derselben Schreibschicht gebildet ist, wie die der ersten Schreibleitung (WBL).

3. Gerät nach Anspruch 1, **dadurch gekennzeichnet, dass** die erste Verbindungsleitung (CONWBL) in einem zentralen Bereich der ersten Schreibleitungen (WBL) platziert ist.

4. Gerät nach Anspruch 1, **dadurch gekennzeichnet, dass** die Zahl der Speicherzellen (MTJ), die elektrisch oder magnetisch, oder elektrisch und magnetisch zu einer der ersten Schreibleitungen (WBL) verbunden sind, gleich auf gegenüberliegenden Seiten der ersten Verbindungsleitung (CONWBL) ist.

5. Gerät nach Anspruch 1, **dadurch gekennzeichnet, dass** die erste Verbindungsleitung (CONWBL) n-te Potenz von 2 (n ist eine natürliche Zahl) erste Schreibleitungen (WBL) elektrisch zueinander verbindet.

6. Gerät nach Anspruch 1, **dadurch gekennzeichnet, dass** die Anzahl der ersten Schreibleitungen (WBL), die elektrisch durch die erste Verbindungsleitung (CONWBL) verbunden sind, mindestens die Zahl der ersten Schreibleitungen ist, welche innerhalb einer Redundanz-Ersatzeinheit beinhaltet sind.

7. Gerät nach Anspruch 1, **gekennzeichnet durch** ferner umfassend:
eine Vielzahl von redundanten Speicherzellen (RMTJ), um defekte Speicherzellen zu ersetzen;
eine Vielzahl von redundanten Schreibleitungen (RWBL), die elektrisch oder magnetisch, oder elektrisch und magnetisch zu den redundanten Speicherzellen verbunden sind und entlang der ersten Richtung bereitgestellt sind; und
eine redundante Verbindungsleitung (CONWBL), welche mindestens zwei der redundanten Schreibleitungen miteinander verbindet, wobei die Zahl der ersten Schreibleitungen, die elektrisch miteinander verbunden sind, mindestens die Zahl der redundanten Schreibleitungen ist, die elektrisch zueinander verbunden sind.

8. Gerät nach Anspruch 1, **dadurch gekennzeichnet, dass** die Speicherzellen (MTJ) Magneto-Resistenz-Elemente beinhalten,
wobei die Magneto-Resistenz-Elemente periodisch angeordnet sind, und
eine Distanz (La) zwischen den Magneto-Resistenz-Elementen innerhalb der Speicherzellen neben der ersten Verbindungsleitung (CONWBL) und der ersten Verbindungsleitung größer ist als ein Abstand (Lb) zwischen periodisch angeordneten Magneto-Resistenz-Elementen.

9. Gerät nach Anspruch 1, **gekennzeichnet durch** ferner umfassend:
eine Vielzahl von zweiten Schreibleitungen (WBL), die elektrisch oder magnetisch, oder elektrisch und magnetisch zu den Speicherzellen (MTJ) verbunden sind und entlang einer zweiten Richtung bereitgestellt sind, die unterschiedlich ist von der ersten Richtung; und
eine zweite Verbindungsleitung (CONWBL), welche mindestens zwei der zweiten Schreibleitungen elektrisch miteinander verbindet.

10. Gerät nach Anspruch 9, **dadurch gekennzeichnet, dass** eine der Speicherzellen (MTJ) an einer Kreuzung zwischen einer der ersten Schreibleitungen (WBL) und einer der zweiten Schreibleitungen (WBL) platziert ist,
wobei die eine der ersten Schreibleitungen in einer Schreibschicht über der der Speicherzellen gebildet ist, und die eine der zweiten Schreibleitungen in einer Schreibschicht unter der der Speicherzellen gebildet ist.

11. Gerät nach Anspruch 9, **dadurch gekennzeichnet, dass** die Zahl der ersten Schreibleitungen (WBL), die elektrisch zueinander verbunden sind, mindestens die Zahl der zweiten Schreibleitungen (WBL) ist, die elektrisch zueinander verbunden sind.

12. Gerät nach Anspruch 9, **dadurch gekennzeichnet, dass** die Zahl der Speicherzellen (MTJ), die elektrisch oder magnetisch, oder elektrisch und magnetisch zueinander verbunden sind, maximal die Zahl der Speicherzellen ist, die elektrisch oder magnetisch, oder elektrisch und magnetisch miteinander verbunden sind.

13. Gerät nach Anspruch 1, **dadurch gekennzeichnet, dass** zwei nebeneinander liegende der ersten Schreibleitungen ein erstes Schreibleitungspaar (WBL, /WBL) darstellen,
eine Vielzahl von ersten Schreibleitungspaaren angeordnet sind,
die erste Verbindungsleitung (CONWBL) eine Vielzahl von den ersten Schreibleitungen zueinander elektrisch verbindet, die eine der ersten Schreibleitungen des ersten Schreibleitungspaars darstellen, und
eine zweite Verbindungsleitung (/CONWBL) eine Vielzahl der ersten Schreibleitungen elektrisch miteinander verbinden, die eine andere erste Schreibleitung des ersten Schreibleitungspaars darstellen.

14. Gerät nach Anspruch 1, **dadurch gekennzeichnet, dass** eine erste Schreibschaltung (WBLD) zu einem Ende der ersten Schreibleitungen verbunden ist,
eine zweite Schreibschaltung (WBLD) zu einem anderen Ende der ersten Schreibleitungen verbunden ist,
die erste Schreibschaltung eine Spannungsquellenschaltung beinhaltet, welche eine Schreibspannung liefert zu den ersten Schreibleitungen und die zweite Schreibschaltung eine Spannungssenkenschaltung beinhaltet, die eine Schreibspannung aus den ersten Schreibleitungen zieht, oder die ersten Schreibschaltungen und die zweiten Schreibschaltungen die Spannungsquellenschaltung und die Spannungssenkenschaltung beinhalten, und
die Zahl der Spannungsquellenschaltungen, die während einer Schreiboperation aktiviert sind, unterschiedlich ist von der Zahl der Spannungssenkenschaltungen, die während einer Schreiboperation aktiviert sind.

15. Gerät nach Anspruch 14, **dadurch gekennzeichnet, dass** eine Vielzahl der ersten Schreibleitungen (WBL), die elektrisch zueinander verbunden sind, eine erste Schreibleitungsgruppe darstellen, und
während einer Schreiboperation der ersten Schreibschaltung (WBLD) und der zweiten Schreibschaltung (WBLD), welche zu der ersten Schreibleitungsgruppe verbunden sind, eine der Spannungsquellenschaltungen und eine Vielzahl der Spannungssenkenschaltungen aktiviert sind oder eine der Spannungssenkenschaltungen und eine Vielzahl der Spannungsquellenschaltungen aktiviert sind.

16. Gerät nach Anspruch 14, **dadurch gekennzeichnet, dass** eine Vielzahl der ersten Schreibleitungen (WBL), welche elektrisch zueinander verbunden sind, eine erste Schreibleitungsgruppe darstellen, und
während einer Schreiboperation der ersten Schreibschaltungen und der zweiten Schreibschaltungen, welche zu der ersten Schreibschaltungsgruppe verbunden sind,
wenn eine der Spannungsquellenschaltungen und eine Vielzahl der Spannungssenkenschaltungen aktiviert sind, die erste Schreibschaltung oder zweite Schreibschaltung neben der Spannungsquellenschaltung, die aktiviert ist, nicht aktiviert ist, und
wenn eine der Spannungssenkenschaltungen und eine Vielzahl der Spannungsquellenschaltungen operieren, die erste Schreibschaltung oder zweite Schreibschaltung neben der Spannungssenkenschaltung, die operiert, inaktiviert ist.

17. Gerät nach Anspruch 14, **dadurch gekennzeichnet, dass** eine Vielzahl der ersten Schreibleitungen (WB1), die elektrisch zueinander verbunden sind, eine erste Schreibleitungsgruppe darstellen, und
während einer Schreiboperation, eine Vielzahl der ersten Schreibschaltungen und einer Vielzahl der zweiten Schreibschaltungen, welche an einer Seite des Geräts lokalisiert sind, an welcher eine Schreibzielspeicherzelle lokalisiert ist, mit Bezug auf die erste Verbindungsleitung,
alle ersten Schreibschaltungen und die zweiten Schreibschaltungen außer die, die zu der ersten Schreibleitung verbunden sind, elektrisch oder magnetisch oder elektrisch und magnetisch verbunden zu der ersten Schreibzielspeicherzelle, inaktiviert sind.

18. Gerät nach Anspruch 14, **dadurch gekennzeichnet, dass** eine Vielzahl der ersten Schreibleitungen (WBL), die elektrisch zueinander verbunden sind, eine Vielzahl von ersten Schreibleitungsgruppen darstellen, und
alle ersten Schreibleitungen von mindestens einer der ersten Schreibleitungsgruppen, die erste Schreibleitung nicht beinhaltend, elektrisch oder magnetisch oder elektrisch und magnetisch zu einer Schreibzielspeicherzelle verbunden, auf ein gleiches Potential vorgeladen werden.

19. Gerät nach Anspruch 14, **dadurch gekennzeichnet, dass** eine Vielzahl der ersten Schreibleitungen (WBL), die elektrisch zueinander verbunden sind, eine erste Schreibleitungsgruppe darstellen,
die Speicherzellen (MTJ) ein Speicherzellen-Array darstellen,
eine Vielzahl der ersten Schreibschaltungen durch ein erstes Adressensignal gesteuert sind zum Auswählen der Speicherzelle, die an einer Seite des Speicherzellen-Arrays lokalisiert ist, mit Bezug auf die erste Verbindungsleitung,
eine Vielzahl der zweiten Schreibschaltungen durch ein zweites Adresssignal gesteuert sind zum Auswählen der Speicherzelle, die an einer anderen Seite des Speicherzellen-Arrays lokalisiert sind, mit Bezug auf die erste Verbindungsleitung, und
das erste Adressensignal das zweite Adressensignal komplementär sind.

20. Gerät nach Anspruch 14, **dadurch gekennzeichnet, dass** eine Vielzahl der ersten Schreibleitungen (WBL), die elektrisch zueinander verbunden sind, eine erste Schreibleitungsgruppe darstellen,
eine Vielzahl der ersten Schreibschaltungen durch ein erstes Schreibdaten-Polaritätssignal gesteuert sind, das anzeigt, dass Daten mit einer ersten Polarität zu der Speicherzelle zu schreiben sind,
eine Vielzahl der zweiten Schreibschaltungen durch ein zweites Schreibdaten-Polaritätssignal gesteuert sind, das zeigt, dass Daten mit einer zweiten Polarität zu der Speicherzelle zu schreiben sind, und
das erste Schreibdaten-Polaritätssignal und das zweite Schreibdaten-Polaritätssignal komplementär sind.

21. Gerät nach Anspruch 14, **dadurch gekennzeichnet, dass** eine Vielzahl der ersten Schreibleitungen (WBL), die elektrisch zueinander verbunden sind, eine Vielzahl von ersten Schreibleitungsgruppen darstellen,
die ersten Schreibleitungsgruppen aus einer gleichen Zahl der ersten Schreibleitungen bestehen, und
eine von einer Vielzahl der ersten Schreibschaltungen und eine von einer Vielzahl von zweiten Schreibschaltungen, die zu einer der ersten Schreibleitungen der ersten Schreibleitungsgruppen verbunden sind, durch ein gleiches Adresssignal gesteuert sind.

22. Gerät nach Anspruch 14, **dadurch gekennzeichnet, dass** ein Schreiboperationssteuersignal zu den ersten Schreibschaltungen und den zweiten Schreibschaltungen zugeführt wird, um ein Timing zu steuern für Start oder Ende, oder Start und Ende einer Schreiboperation.

23. Gerät nach Anspruch 1, **dadurch gekennzeichnet, dass** eine der ersten Schreibleitungen elektrisch verbunden ist zu einer ersten gemeinsamen Leitung (VCONWBL1) über eine erste Schalterschaltung (SWBL1),
ein anderes Ende der ersten Schreibleitungen elektrisch verbunden ist zu einer zweiten gemeinsamen Leitung (VCONBBL2) über eine zweite Schalterschaltung (SWBL2),
eine erste Schreibschaltung (WBLD1) zu der ersten gemeinsamen Leitung verbunden ist,
eine zweite Schreibschaltung (WBLD2) zu der zweiten gemeinsamen Leitung verbunden ist,
die erste Schreibschaltung eine Spannungsquellenschaltung beinhaltet, welche eine Schreibspannung zu der ersten gemeinsamen Leitung zuführt und die zweite Schreibschaltung eine Spannungssenkenschaltung beinhaltet, welche eine Schreibspannung aus der zweiten gemeinsamen Leitung zieht, oder die erste Schreibschaltung und die zweite Schreibschaltung die Spannungsquellenschaltung und die Spannungssenkenschaltung beinhalten, und
die Zahl der eingeschalteten ersten Schalterschaltungen unterschiedlich ist von derer der eingeschalteten zweiten Schalterschaltungen während einer Schreiboperation.

24. Gerät nach Anspruch 23, **dadurch gekennzeichnet, dass** eine Vielzahl der ersten Schreibleitungen (WBL), die elektrisch zueinander verbunden sind, eine erste Schreibleitungsgruppe darstellen, und
während einer Schreiboperation von einer Vielzahl von ersten Schalterschaltungen und einer Vielzahl von zweiten Schalterschaltungen, welche zu der ersten Schreibleitungsgruppe verbunden sind, eine der ersten Schalterschaltungen und eine Vielzahl der zweiten Schalterschaltungen an sind, oder eine der zweiten Schalterschaltungen und eine Vielzahl der ersten Schalterschaltungen an sind.

25. Gerät nach Anspruch 23, **dadurch gekennzeichnet, dass** eine Vielzahl der ersten Schreibleitungen (WBL), die elektrisch zueinander verbunden sind, eine erste Schreibleitungsgruppe darstellen,
eine Vielzahl der ersten Schreibleitungsgruppen angeordnet sind,
der ersten Schalterschaltungen und zweiten Schalterschaltungen, die zu mindestens einer der ersten Schreibleitungsgruppen verbunden sind, nicht die erste Schreibleitung beinhaltend, elektrisch oder magnetisch oder elektrisch und magnetisch verbunden zu einer Schreibziel-Speicherzelle,
alle ersten Schalterschaltungen aus sind und eine Vielzahl der zweiten Schalterschaltungen an sind, und alle zweiten Schalterschaltungen aus sind und eine Vielzahl der ersten Schalterschaltungen an sind.

26. Gerät nach Anspruch 23, **dadurch gekennzeichnet, dass** eine Vielzahl der ersten Schreibleitungen (WBL), die elektrisch zueinander verbunden sind, eine erste Schreibleitungsgruppe darstellen, und
alle ersten Schreibleitungen von mindestens einer der ersten Schreibleitungsgruppen, die erste Schreibleitung nicht beinhaltend, elektrisch oder magnetisch, oder elektrisch und magnetisch verbunden zu einer Schreibziel-Speicherzelle, vorgeladen werden auf ein gleiches Potential.

27. Gerät nach Anspruch 23, **dadurch gekennzeichnet, dass** eine Vielzahl der ersten Schreibleitungen (WBL), die elektrisch zueinander verbunden sind, eine erste Schreibleitungsgruppe darstellen,
die Speicherzellen (MTJ) ein Speicherzellen-Array darstellen,
eine Vielzahl der ersten Schalterschaltungen gesteuert werden durch ein erstes Adressensignal (LSEL) zum Auswählen der Speicherzelle, die auf einer Seite des Speicherzellen-Arrays lokalisiert ist, mit Bezug auf die erste Verbindungsleitung,
eine Vielzahl der zweiten Schalterschaltungen durch ein zweites Adressensignal (RSEL) gesteuert werden zum Auswählen der Speicherzelle, die an einer anderen Seite des Speicherzellen-Arrays lokalisiert ist, mit Bezug auf die erste Verbindungsleitung, und
das erste Adressensignal und das zweite Adressensignal komplementär zueinander sind.

28. Gerät nach Anspruch 23, **dadurch gekennzeichnet, dass** eine Vielzahl der ersten Schreibleitungen (WBL), die elektrisch zueinander verbunden sind, eine erste Schreibleitungsgruppe darstellen,
eine Vielzahl der ersten Schalterschaltungen gesteuert sind durch ein erstes Schreibdaten-Polaritätssignal (DATO), das anzeigt, dass Daten mit einer ersten Polarität zu der Speicherzelle zu schreiben sind,
eine Vielzahl der zweiten Schalterschaltungen gesteuert werden durch ein zweites Schreibdaten-Polaritätssignal (DAT1), das anzeigt, dass Daten mit einer zweiten Polarität zu der Speicherzelle zu schreiben sind, und
das erste Schreibdaten-Polaritätssignal und das zweite Schreibdaten-Polaritätssignal komplementär zueinander sind.

29. Gerät nach Anspruch 23, **dadurch gekennzeichnet, dass** eine Vielzahl der ersten Schreibleitung (WBL), die elektrisch zueinander verbunden sind, eine Vielzahl von ersten Schreibleitungsgruppen darstellen,
die ersten Schreibleitungsgruppen von einer ersten Zahl von ersten Schreibleitungen gebildet werden, und
eine einer Vielzahl der ersten Schalterschaltungen und eine einer Vielzahl der zweiten Schalterschaltungen, die verbunden sind zu einer der ersten Schreibleitungen der ersten Schreibleitungsgruppen, gesteuert werden durch das gleiche Adressensignal (SEL(n)).

30. Gerät nach Anspruch 23, **dadurch gekennzeichnet, dass** ein Schreiboperationssteuersignal (WACT) zu den ersten Schalterschaltungen und den zweiten Schalterschaltungen zugeführt wird, um ein Timing für Start oder Ende, oder Start und Ende einer Schreiboperation zu steuern.

31. Gerät nach Anspruch 23, **gekennzeichnet durch** ferner umfassen einer dritten Schalterschaltung (SWPWBL), die zwischen einer der Vielzahl der ersten Schreibleitungen und einer ersten Potentialleitung verbunden ist.

## Revendications

1. Dispositif de mémoire à semi-conducteurs comprenant :
une pluralité de cellules mémoire utilisant un courant circulant à travers un câblage (MTJ) ;
une pluralité de premières lignes d'écriture (WBL) connectées électriquement ou magnétiquement ou électriquement et magnétiquement aux cellules mémoire et prévues le long d'une première direction ; et
une première ligne de connexion (CONWBL) qui connecte électriquement une première des premières lignes d'écriture à une deuxième des premières lignes d'écriture, **caractérisé en ce que** :
chacune des premières lignes d'écriture a une première extrémité et une deuxième extrémité, les premières extrémités étant situées d'un côté de la première ligne de connexion et les deuxièmes extrémités étant situées de l'autre côté de la première ligne de connexion, chacune de ladite première et de ladite deuxième des premières lignes d'écriture étant couplée à au moins une cellule mémoire entre la première extrémité et la première ligne de connexion (CONWBL) et étant couplée à au moins une autre cellule mémoire entre la première ligne de connexion (CONWBL) et la deuxième extrémité, le dispositif de mémoire à semi-conducteurs comprenant en outre un circuit d'écriture adapté pour générer un courant d'écriture pendant une opération d'écriture, où :
le courant d'écriture, dans une opération d'écriture, pénètre dans la première extrémité de la première des premières lignes d'écriture (WBL) connectée par la première ligne de connexion (CONWBL) à la deuxième des premières lignes d'écriture, et le courant d'écriture sort par la deuxième extrémité de la première des premières lignes d'écriture et par au moins l'une des première et deuxième extrémités de la deuxième des premières lignes d'écriture, ou bien
le courant d'écriture pénètre dans la première extrémité de la première des premières lignes d'écriture (WBL) et dans au moins la première extrémité de la deuxième des premières lignes d'écriture connectée par la première ligne de connexion à la première des premières lignes d'écriture, et le courant d'écriture sort par la deuxième extrémité de la première des premières lignes d'écriture (WBL).

2. Dispositif selon la revendication 1, **caractérisé en ce que** la première ligne de connexion (CONWBL) est formée dans la même couche de câblage que celle des premières lignes d'écriture (WBL).

3. Dispositif selon la revendication 1, **caractérisé en ce que** la première ligne de connexion (CONWBL) est placée dans une partie centrale des premières lignes d'écriture (WBL).

4. Dispositif selon la revendication 1, **caractérisé en ce que** le nombre de cellules mémoire (MTJ) qui sont connectées électriquement ou magnétiquement ou électriquement et magnétiquement à l'une des premières lignes d'écriture (WBL) est égal de chaque côté de la première ligne de connexion (CONWBL).

5. Dispositif selon la revendication 1, **caractérisé en ce que** la première ligne de connexion (CONWBL) connecte électriquement entre elles 2ⁿ (n est un entier naturel) premières lignes d'écritures (WBL).

6. Dispositif selon la revendication 1, **caractérisé en ce que** le nombre des premières lignes d'écriture (WBL) qui sont connectées électriquement par la première ligne de connexion (CONWBL) est au moins égal au nombre des premières lignes d'écriture qui sont incluses dans une unité de remplacement de redondance.

7. Dispositif selon la revendication 1, **caractérisé en ce qu'**il comprend en outre :
une pluralité de cellules mémoire redondantes (RMTJ) pour remplacer une cellule mémoire défectueuse ;
une pluralité de lignes d'écriture redondantes (RWBL) connectées électriquement ou magnétiquement ou électriquement et magnétiquement aux cellules mémoire redondantes et prévues le long de la première direction ; et
une ligne de connexion redondante (CONWBL) qui connecte électriquement entre elles au moins deux des lignes d'écriture redondantes, le nombre des premières lignes d'écriture qui sont connectées électriquement entre elles étant au moins égal au nombre des lignes d'écriture redondantes qui sont connectées électriquement entre elles.

8. Dispositif selon la revendication 1, **caractérisé en ce que** les cellules mémoire (MTJ) comprennent des éléments magnétorésistifs,
les éléments magnétorésistifs sont agencés de façon périodique, et
une distance (La) entre les éléments magnétorésistifs situés dans la cellule mémoire contiguë à la première ligne de connexion (CONWBL) et la première ligne de connexion est supérieure à un espacement (Lb) entre les éléments magnétorésistifs agencés de façon périodique.

9. Dispositif selon la revendication 1, **caractérisé en ce qu'**il comprend en outre :
une pluralité de deuxièmes lignes d'écriture (WWL) connectées électriquement ou magnétiquement ou électriquement et magnétiquement aux cellules mémoire (MTJ) et prévues le long d'une deuxième direction différente de la première direction ; et
une deuxième ligne de connexion (CONWWL) qui connecte électriquement entre elles au moins deux des deuxièmes lignes d'écriture.

10. Dispositif selon la revendication 9, **caractérisé en ce que** l'une des cellules mémoire (MTJ) est placée à une intersection entre l'une des premières lignes d'écriture (WBL) et l'une des deuxièmes lignes d'écriture (WWL),
ladite première ligne d'écriture en question étant formée dans une couche de câblage située au dessus de ladite cellule mémoire en question, et ladite deuxième ligne d'écriture en question étant formée dans une couche de câblage située en dessous de ladite cellule mémoire en question.

11. Dispositif selon la revendication 9, **caractérisé en ce que** le nombre des premières lignes d'écriture (WBL) qui sont connectées électriquement entre elles est au moins égal au nombre des deuxièmes lignes d'écriture (WWL) qui sont connectées électriquement entre elles.

12. Dispositif selon la revendication 9, **caractérisé en ce que** le nombre des cellules mémoire (MTJ) qui sont connectées électriquement ou magnétiquement ou électriquement et magnétiquement entre elles est au plus égal au nombre des cellules mémoire qui sont connectées électriquement ou magnétiquement ou électriquement et magnétiquement entre elles.

13. Dispositif selon la revendication 1, **caractérisé en ce que** deux contiguës des premières lignes d'écriture constituent une paire de premières de lignes d'écriture (WBL, /WBL),
il est prévu une pluralité de paires des premières lignes d'écriture,
la première ligne de connexion (CONWBL) connecte électriquement entre elles une pluralité des premières lignes d'écriture constituant l'une des premières lignes d'écriture de la paire de premières lignes d'écriture, et
une deuxième ligne de connexion (/CONWBL) connecte électriquement entre elles une pluralité des premières lignes d'écriture constituant l'autre première ligne d'écriture de la paire de premières lignes d'écriture.

14. Dispositif selon la revendication 1, **caractérisé en ce qu'**un premier circuit d'écriture (WBLD) est connecté à une extrémité des premières lignes d'écriture,
un deuxième circuit d'écriture (WBLD) est connecté à l'autre extrémité des premières lignes d'écriture,
le premier circuit d'écriture comprend un circuit source de courant qui fournit un courant d'écriture aux premières lignes d'écriture et le deuxième circuit d'écriture comprend un circuit collecteur de courant qui prélève un courant d'écriture des premières lignes d'écriture, ou bien les premiers circuits d'écriture et les deuxième circuits d'écriture comprennent le circuit source de courant et le circuit collecteur de courant, et
le nombre de circuits sources de courant qui sont activés pendant une opération d'écriture est différent du nombre de circuits collecteurs de courant qui sont activés pendant une opération d'écriture.

15. Dispositif selon la revendication 14, **caractérisé en ce qu'**une pluralité des premières lignes d'écriture (WBL) connectées électriquement entre elles constitue un groupe de premières lignes d'écriture, et
pendant une opération d'écriture, parmi les premiers circuits d'écriture (WBLD) et les deuxièmes circuits d'écriture (WBLD) qui sont connectés au groupe de premières lignes d'écriture, l'un des circuits sources de courant et une pluralité des circuits collecteurs de courant sont activés, ou bien l'un des circuits collecteurs de courant et une pluralité de circuits source de courant sont activés.

16. Dispositif selon la revendication 14, **caractérisé en ce qu'**une pluralité des premières lignes d'écriture (WBL) connectées électriquement entre elles constitue un groupe de premières lignes d'écriture, et
pendant une opération d'écriture, parmi les premiers circuits d'écriture et les deuxièmes circuits d'écriture qui sont connectés au groupe de premières lignes d'écriture,
quand l'un des circuits sources de courant et une pluralité des circuits collecteurs de courant sont activés, le premier circuit d'écriture ou le deuxième circuit d'écriture adjacent au circuit source de courant activé est désactivé, et
quand l'un des circuits collecteurs de courant et une pluralité de circuits source de courant fonctionnent, le premier circuit d'écriture ou le deuxième circuit d'écriture adjacent au circuit collecteur de courant qui est en fonctionnement est désactivé.

17. Dispositif selon la revendication 14, **caractérisé en ce qu'**une pluralité des premières lignes d'écriture (WBL) connectées électriquement entre elles constitue un groupe de premières lignes d'écriture, et
pendant une opération d'écriture, parmi une pluralité des premiers circuits d'écriture et une pluralité des deuxièmes circuits d'écriture qui sont situés d'un coté du dispositif sur lequel se trouve une cellule mémoire cible d'écriture par rapport à la première ligne de connexion,
tous les premiers circuits d'écriture et les deuxièmes circuits d'écriture autres que ceux qui sont connectés à la première ligne d'écriture, elle-même connectée électriquement ou magnétiquement ou électriquement et magnétiquement à la cellule mémoire cible d'écriture, sont désactivés.

18. Dispositif selon la revendication 14, **caractérisé en ce qu'**une pluralité des premières lignes d'écriture (WBL) connectées électriquement entre elles constitue une pluralité de groupes de premières lignes d'écriture, et
toutes les premières lignes d'écriture d'au moins l'un des groupes de premières lignes d'écriture, à l'exception de la première ligne d'écriture qui est connectée électriquement ou magnétiquement ou électriquement et magnétiquement à une cellule mémoire cible d'écriture, sont préchargées à un même potentiel.

19. Dispositif selon la revendication 14, **caractérisé en ce qu'**une pluralité des premières lignes d'écriture (WBL) connectées électriquement entre elles constitue un groupe de premières lignes d'écriture,
les cellules mémoire (MTJ) constituent une matrice de cellules mémoire,
une pluralité des premiers circuits d'écriture est commandée par un premier signal d'adresse pour la sélection de la cellule mémoire située sur un côté de la matrice de cellules mémoire par rapport à la première ligne de connexion,
une pluralité des deuxièmes circuits d'écriture est commandée par un deuxième signal d'adresse pour la sélection de la cellule mémoire située sur l'autre côté de la matrice de cellules mémoire par rapport à la première ligne de connexion, et
le premier signal d'adresse et le deuxième signal d'adresse sont complémentaires.

20. Dispositif selon la revendication 14, **caractérisé en ce qu'**une pluralité des premières lignes d'écriture (WBL) connectées électriquement entre elles constitue un groupe de premières lignes d'écriture,
une pluralité des premiers circuits d'écriture est commandée par un premier signal de polarité de données d'écriture indiquant que les données ayant une première polarité doivent être écrites dans la cellule mémoire,
une pluralité de deuxièmes circuits d'écriture est commandée par un deuxième signal de polarité de données d'écriture indiquant que les données ayant une deuxième polarité doivent être écrites dans la cellule mémoire, et
le premier signal de polarité de données d'écriture et le deuxième signal de polarité de données d'écriture sont complémentaires.

21. Dispositif selon la revendication 14, **caractérisé en ce qu'**une pluralité des premières lignes d'écriture (WBL) connectées électriquement entre elles constitue une pluralité de groupes de premières lignes d'écriture,
les groupes de premières lignes d'écriture sont composés du même nombre de premières lignes d'écriture, et
l'un d'une pluralité des premiers circuits d'écriture et l'un d'une pluralité des deuxièmes circuits d'écriture qui sont connectés à l'une des premières lignes d'écriture des groupes de premières lignes d'écriture sont commandés par un même signal d'adresse.

22. Dispositif selon la revendication 14, **caractérisé en ce qu'**un signal de commande d'opération d'écriture est fourni aux premiers circuits d'écriture et aux deuxièmes circuits d'écriture pour commander un minutage de début ou de fin ou de début et de fin d'une opération d'écriture.

23. Dispositif selon la revendication 1, **caractérisé en ce qu'**une extrémité des premières lignes d'écriture est connectée électriquement à une première ligne commune (VCONWBL1) via un premier circuit de commutation (SWBL11),
une autre extrémité des premières lignes d'écriture est connectée électriquement à une deuxième ligne commune (VCONWBL2) via un deuxième circuit de commutation (SWBL2),
un premier circuit d'écriture (WBLD1) est connecté à la première ligne commune,
un deuxième circuit d'écriture (WBLD2) est connecté à la deuxième ligne commune,
le premier circuit d'écriture comprend un circuit source de courant qui fournit un courant d'écriture à la première ligne commune et le deuxième circuit d'écriture comprend un circuit collecteur de courant qui prélève un courant d'écriture de la deuxième ligne commune, ou bien le premier circuit d'écriture et le deuxième circuit d'écriture comprennent le circuit source de courant et le circuit collecteur de courant, et
le nombre de premiers circuits de commutation à l'état passant est différent du nombre de deuxièmes circuits de commutation à l'état passant pendant une opération d'écriture.

24. Dispositif selon la revendication 23, **caractérisé en ce qu'**une pluralité des premières lignes d'écriture (WBL) connectées électriquement entre elles constitue un groupe de premières lignes d'écriture, et
pendant une opération d'écriture, parmi une pluralité des premiers circuits de commutation et une pluralité des deuxièmes circuits de commutation qui sont connectés au groupe de premières lignes d'écriture, l'un des premiers circuits de commutation et une pluralité des deuxièmes circuits de commutation sont à l'état passant, ou bien l'un des deuxièmes circuits de commutation et une pluralité des premiers circuits de commutation sont à l'état passant.

25. Dispositif selon la revendication 23, **caractérisé en ce qu'**une pluralité des premières lignes d'écriture (WBL) connectées électriquement entre elles constitue un groupe de premières lignes d'écriture,
il est prévu une pluralité de groupes des premières lignes d'écriture,
parmi les premiers circuits de commutation et les deuxièmes circuits de commutation qui sont connectés à au moins l'un des groupes de premières lignes d'écriture, à l'exception de la première ligne d'écriture qui est connectée électriquement ou magnétiquement ou électriquement et magnétiquement à une cellule mémoire cible d'écriture,
tous les premiers circuits de commutation sont à l'état non passant et une pluralité des deuxièmes circuits de commutation sont à l'état passant, et tous les deuxièmes circuits de commutation sont à l'état non passant et une pluralité des premiers circuits de commutation sont à l'état passant.

26. Dispositif selon la revendication 23, **caractérisé en ce qu'**une pluralité des premières lignes d'écriture (WBL) connectées électriquement entre elles constitue un groupe de premières lignes d'écriture, et
toutes les premières lignes d'écriture d'au moins l'un des groupes de premières lignes d'écriture, à l'exception de la première ligne d'écriture qui est connectée électriquement ou magnétiquement ou électriquement et magnétiquement à une cellule mémoire cible d'écriture, sont préchargées à un même potentiel.

27. Dispositif selon la revendication 23, **caractérisé en ce qu'**une pluralité des premières lignes d'écriture (WBL) connectées électriquement entre elles constitue un groupe de premières lignes d'écriture,
les cellules mémoire (MTJ) constituent une matrice de cellules mémoire,
une pluralité des premiers circuits de commutation est commandée par un premier signal d'adresse (LSEL) pour la sélection de la cellule mémoire située sur un côté de la matrice de cellules mémoire par rapport à la première ligne de connexion,
une pluralité des deuxièmes circuits de commutation est commandée par un deuxième signal d'adresse (RSEL) pour la sélection de la cellule mémoire située sur l'autre côté de la matrice de cellules mémoire par rapport à la première ligne de connexion, et
le premier signal d'adresse et le deuxième signal d'adresse sont complémentaires l'un de l'autre.

28. Dispositif selon la revendication 23, **caractérisé en ce qu'**une pluralité des premières lignes d'écriture (WBL) connectées électriquement entre elles constitue un groupe de premières lignes d'écriture,
une pluralité des premiers circuits de commutation est commandée par une premier signal de polarité de données d'écriture (DAT0) indiquant que les données ayant une première polarité doivent être écrites dans la cellule mémoire,
une pluralité des deuxièmes circuits de commutation est commandée par un deuxième signal de polarité de données d'écriture (DAT1) indiquant que les données ayant une deuxième polarité doivent être écrites dans la cellule mémoire, et
le premier signal de polarité de données d'écriture et le deuxième signal de polarité de données d'écriture sont complémentaires l'un de l'autre.

29. Dispositif selon la revendication 23, **caractérisé en ce qu'**une pluralité des premières lignes d'écriture (WBL) connectées électriquement entre elles constitue une pluralité de groupes de premières lignes d'écriture,
les groupes de premières lignes d'écriture sont composés du même nombre de premières lignes d'écriture, et
l'un d'une pluralité des premiers circuits de commutation et l'un d'une pluralité des deuxièmes circuits de commutation qui sont connectés à l'une des premières lignes d'écriture des groupes de premières lignes d'écriture sont commandés par un même signal d'adresse (SEL(n)).

30. Dispositif selon la revendication 23, **caractérisé en ce qu'**un signal de commande d'opération d'écriture (WACT) est fourni aux premiers circuits de commutation et aux deuxièmes circuits de commutation pour commander un minutage de début ou de fin ou de début et de fin d'une opération d'écriture.

31. Dispositif selon la revendication 23, **caractérisé en ce qu'**il comprend en outre un troisième circuit de commutation (SWPWBL) connecté entre l'une de la pluralité de premières lignes d'écriture et une première ligne de potentiel.
